(19) Europäisches Patentamt
European Patent Office
Office européen des brevets

(11) **EP 3 462 205 B1**

(12) **EUROPÄISCHE PATENTSCHRIFT**

(45) Veröffentlichungstag und Bekanntmachung des Hinweises auf die Patenterteilung:
**06.11.2024   Patentblatt 2024/45**

(21) Anmeldenummer: **17194004.2**

(22) Anmeldetag: **29.09.2017**

(51) Internationale Patentklassifikation (IPC):
**G01R 33/483** (2006.01)   **G01R 33/50** (2006.01)
**G01R 33/56** (2006.01)   G01R 33/561 (2006.01)
**G01R 33/563** (2006.01)

(52) Gemeinsame Patentklassifikation (CPC):
**G01R 33/4835; G01R 33/50; G01R 33/5602;**
**G01R 33/5611; G01R 33/5616;** G01R 33/5607;
G01R 33/5617; G01R 33/56341

(54) **SIMULTANE MAGNETRESONANZ-MULTI-KONTRASTAUFNAHME**

SIMULTANEOUS MAGNETIC RESONANCE MULTI-CONTRAST ACQUISITION

MULTI-EXAMEN DE CONTRASTE PAR RÉSONANCE MAGNÉTIQUE SIMULTANÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.04.2019   Patentblatt 2019/14**

(73) Patentinhaber: **Siemens Healthineers AG**
**91301 Forchheim (DE)**

(72) Erfinder: **Zeller, Mario**
**91054 Erlangen (DE)**

(74) Vertreter: **Siemens Healthineers**
**Patent Attorneys**
**Postfach 22 16 34**
**80506 München (DE)**

(56) Entgegenhaltungen:
DE-A1- 102015 222 833    US-A- 4 734 646
US-A- 6 097 185    US-A1- 2017 108 567

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur simultanen Erzeugung von verschiedene Kontraste abbildenden Messdaten eines Untersuchungsobjektes mittels Magnetresonanztechnik.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch $B_0$-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld in der Regel schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Der Wunsch nach immer schnelleren MR-Aufnahmen im klinischen Umfeld führt momentan zu einer Renaissance von Verfahren, bei denen mehrere Bilder simultan aufgenommen werden. Allgemein lassen sich diese Verfahren dadurch charakterisieren, dass zumindest während eines Teils der Messung gezielt Transversalmagnetisierung von zumindest zwei Schichten gleichzeitig für den Bildgebungsprozess genutzt wird ("Multi-Schicht-Bildgebung", "Schicht-Multiplexing"). Im Gegensatz dazu wird bei der etablierten "Mehrschicht-Bildgebung" das Signal von zumindest zwei Schichten alternierend, d. h. vollständig unabhängig voneinander mit entsprechender längerer Messzeit aufgenommen.

Bekannte Verfahren hierzu sind beispielsweise die sogenannte Hadamard-Kodierung, Verfahren mit simultaner Echo-Refokussierung, Verfahren mit Breitband-Datenaufnahme oder auch Verfahren, die eine parallele Bildgebung in SchichtRichtung einsetzten. Zu den letztgenannten Verfahren gehören beispielsweise auch die CAIPIRINHA-Technik, wie sie von Breuer et al. in "Controlled Aliasing in Parallel Imaging Results in Higher Acceleration (CAIPIRINHA) for Multi-Slice Imaging", Magnetic Resonance in Medicine 53, 2005, S. 684-691 beschrieben ist, und die blipped CAIPIRINHA-Technik, wie sie von Setsompop et al. in "Blipped-Controlled Aliasing in Parallel Imaging for Simultaneous Multislice Echo Planar Imaging With Reduced g-Factor Penalty", Magnetic Resonance in Medicine 67, 2012, S. 1210-1224, beschrieben wird.

Insbesondere bei den letztgenannten Schichtmultiplexing-Verfahren wird meist ein sogenannter Multi-Band-RF-Puls verwendet, um zwei oder mehr Schichten gleichzeitig anzuregen oder anderweitig zu manipulieren, z.B. zu refokussieren oder zu sättigen. Ein solcher Multi-Band-RF-Puls ist dabei z.B. ein Multiplex von individuellen RF-Pulsen, die zur Manipulation der einzelnen gleichzeitig zu manipulierenden Schichten verwendet werden würden. Durch das Multiplexing erhält man z.B. einen grundbandmodulierten Multi-Band-RF-Puls aus einer Addition der Pulsformen der individuellen RF-Pulse. Die Ortskodierung der aufgenommenen Signale wird dabei im Wesentlichen durch eine gängige Gradientenschaltung in zwei Richtungen (zweidimensionale Gradientenkodierung) erreicht. Es ist jedoch auch möglich, die anzuregenden Schichten, aus denen Echosignale simultan aufgenommenen werden, d.h. innerhalb einer Aufnahme von Messdaten, jeweils mit einzelnen, z.B. sukzessive geschalteten RF-Pulsen, anzuregen und zu manipulieren. Auch eine kombinierte Verwendung von "Einzelschicht"-RF-Pulsen und Multi-Band-RF-Pulsen ist möglich.

Die entstehenden Signale werden aus allen angeregten Schichten kollabiert in einem Datensatz mittels mehreren Empfangsantennen aufgenommen und dann mit Hilfe von parallelen Akquisitionstechniken nach den einzelnen Schichten getrennt.

Zu den genannten parallelen Akquisitionstechniken (ppa-Techniken), mit deren Hilfe sich bereits generell zur Aufnahme der gewünschten Daten benötigte Akquisitionszeiten durch eine gemäß Nyquist nicht vollständige Abtastung, d.h. eine Unterabtastung, des k-Raums verkürzen lassen, zählen z.B. GRAPPA ("GeneRalized Autocalibrating Partially Parallel Acquisition") und SENSE ("SENSitivity Encoding"). Die im Rahmen der Unterabtastung nicht-gemessenen Messpunkte im k-Raum sind bei parallelen Akquisitionstechniken in der Regel gleichmäßig über den gemäß Nyquist zu messenden k-Raum verteilt, sodass z.B. jede zweite (Beschleunigungsfaktor 2) oder dritte (Beschleunigungsfaktor 3) usw. k-Raumzeile gemessen wird. Darüber hinaus werden die "fehlenden" k-Raumdaten bei parallelen Akquisitionstechniken mit Hilfe von Spulensensitivitätsdaten rekonstruiert. Diese Spulensensitivitätsdaten der bei der Aufnahme der Messdaten verwendeten Empfangsspulen werden aus Referenzmessdaten ermittelt, die zumindest einen Bereich des zu messenden k-Raums, meist den zentralen Bereich, vollständig gemäß der Nyquist-Bedingung abtasten.

Bei Schichtmultiplexing-Verfahren werden parallele Akquisitionstechniken verwendet, um die gleichzeitig für verschiedene Schichten aufgenommenen Messdaten wieder in Messdaten der einzelnen Schichten zu trennen. Dabei müssen Referenzmessdaten für alle betroffenen Schichten ermittelt werden. Dies geschieht in der Regel im Rahmen einer zusätzlich durchzuführenden Referenzmessung, die Referenzmessdaten einzeln für jede gewünschte Schicht misst. Es sind mittlerweile auch Verfahren bekannt, bei denen zur Ermittlung der Referenzmessdaten keine separate Referenzmessung mehr benötigt wird, sondern z.B. die Referenzmessung mit der Messung der Schichtmultiplexing-Messdaten verschachtelt ist, wie es z.B. in der nachveröffentlichten US-Patentanmeldung US 2017/108567 A1 beschrieben ist, oder die Referenzdaten sogar aus den Schichtmultiplexing-Messdaten ermittelt werden, wie es z.B. in der nachveröffentlichten EP17174507 beschrieben ist.

Um die resultierenden Signale der verschiedenen Schichten trennen zu können, wird beispielsweise den individuellen RF-Pulsen (ggf. vor dem Multiplexing), z.B. durch Addieren einer Phase, die linear (z.B. mit der k-Raumkoordinate in die Phasenkodierrichtung ($k_y$)) steigt, je eine unterschiedliche Phase aufgeprägt. Damit kann jeder Schicht ein unterschiedlicher Phasenanstieg aufgeprägt werden, wodurch die Schichten im Bildraum gegeneinander verschoben werden. Diese Verschiebung wird durch den sogenannten Bildbereich-Verschiebungsfaktor ("FOV (field of view) shift factor" oder "interslice FOV shift") kontrolliert. Wie ein optimaler FOV shift factor bestimmt werden kann, wird beispielsweise in der nachveröffentlichten DE102016218955 beschrieben.

In den genannten Artikel von Breuer et al. und Setsompop et al. beschriebenen CAIPIRINHA-Verfahren werden durch Schalten von zusätzlichen Gradientenblips oder durch zusätzliches Modulieren der Phasen der RF-Pulse der Multi-Band-RF-Pulse zwischen den gleichzeitig angeregten Schichten wechselnde weitere Phasenverschiebungen aufgeprägt, die in Schichtrichtung Verschiebungen im Bildraum ("interslice FoV shifts") erzeugen. Diese zusätzlichen Verschiebungen im Bildraum verbessern die Qualität der Trennung der Signale der Schichten, insbesondere, wenn die Spulensensitivitäten derartig geringe Unterschiede in den Sensitivitätsprofilen der einzelnen verwendeten Spulen aufweisen, dass diese nicht für eine zuverlässige Trennung der Schichten ausreichen. Somit werden Artefakte in den letztendlich aus den gemessenen Messdaten rekonstruierten Bilddaten verringert.

Verfahren zur verschachtelten Aufnahme von Messdaten unter Verwendung verschiedener Echozeiten werden in US 2017/0108567 A1, DE 10 2015 222 833 A1, US6097185A und US4734646A beschrieben.

Das wohl meistverwendete Verfahren, um nach einer Anregung der Kernspins Echosignale zu erzeugen, ist das sogenannte Spin-Echo-Verfahren. Im einfachsten Fall wird hierbei durch Einstrahlen mindestens eines RF-Refokussierungspulses nach dem Einstrahlen des RF-Anregungspulses die transversale Magnetisierung sozusagen "gewendet", wodurch sich die dephasierte Magnetisierung wieder rephasiert und somit nach einer als Echozeit bezeichneten Zeit TE nach dem RF-Anregungspuls ein sogenanntes Spinecho SE erzeugt wird.

Die Anregung und die Messung der erzeugten Echosignale werden nach einer Wiederholzeit TR so lange wiederholt (z.B. unter Schaltung verschiedener Gradienten zur Ortskodierung) bis die gewünschte Anzahl an Echosignalen gemessen und im k-Raum gespeichert wurde, um das Untersuchungsobjekt abbilden zu können.

Unter den SE-Sequenzen sind insbesondere die TSE-Sequenzen (TSE: "Turbo Spin Echo"), welche auch unter den Namen FSE-("Fast Spin Echo") oder RARE- ("Rapid Acquisition with Refocused Echoes") Sequenzen bekannt sind, weit verbreitet in der klinischen Anwendung. Der Vorteil der TSE-Sequenzen gegenüber der "einfachen" SE-Sequenz ist, dass nach einem RF-Anregungspuls mehrere Refokussierungspulse geschaltet werden, und dass dadurch auch mehrere Spinechosignale SE nach einer Anregung erzeugt werden (Multiecho-Sequenz). Dadurch wird die Datenaufnahme beschleunigt, da weniger Wiederholungen der Sequenz mit unterschiedlicher Ortskodierung benötigt werden, um alle gewünschten Daten zu messen. Die Messzeit für den gesamten k-Raum ist damit bei TSE-Sequenzen entsprechend der Anzahl der nach einer Anregung refokussierten und aufgenommenen Echosignale, dem sogenannten "Turbofaktor", gegenüber konventioneller SE-Verfahren reduziert.

Andererseits können durch einen RF-Anregungspuls angeregte Kernspins durch Schalten von Dephasierungs- und Rephasierungsgradienten so manipuliert werden, dass das Signal schneller als dem dem gemessenen Gewebe inhärenten T2*-Zerfall geschuldet, zerfällt, sich aber nach einer gewissen Zeit, der Echozeit TE, nach dem RF-Anregungspuls ein sogenanntes messbares Gradientenecho bildet. Derartige Sequenzen werden üblicherweise als GRE-Sequenzen bezeichnet. Auch unter den GRE-Sequenzen gibt es Varianten, die nach einer Anregung mehrere (Gradienten-)Echosignale erzeugen und somit zu den Multiecho-Sequenzen zählen. Als prominente Variante seien EPI-Verfahren ("echo planar imaging") genannt, bei welchen ein oszillierender Auslesegradient eingesetzt wird, der bei jeder Änderung der Polarisationsrichtung des Gradienten die transversale Magnetisierung so weit refokussiert, wie es der T2*-Zerfall erlaubt, und damit je ein Gradientenecho erzeugt.

In der klinischen Anwendung von Magnetresonanztechniken gewinnen neben den meist erzeugten (kontrastgewichteten) MR-Bildern, die das Untersuchungsobjekt in einer Weise darstellen, dass anatomische Informationen gut sichtbar dargestellt werden, auch Parameter-Karten an Bedeutung, die die lokale Verteilung bestimmter Parameter des aufgenommenen Untersuchungsobjekts darstellen. Mögliche Parameter sind hierbei beispielsweise Relaxationsparameter, die den Zerfall der Magnetisierung wiedergeben (insbesondere die longitudinale Relaxation (T1-Zerfall), die transversale Relaxation (T2-Zerfall) und die effektive transversale Relaxation (T2*-Zerfall)), aber auch die Protonendichte $\rho$ oder etwa Diffusionsparameter.

Um derartige Parameterkarten erstellen zu können, die die Verteilung der Protonendichte $\rho$ oder der T1-Zerfallskonstanten oder der T2-Zerfallskonstanten oder der T2*-Zerfallskonstanten darstellen, müssen Echosignale zu verschiedenen Echozeiten oder Inversionszeiten aufgenommen werden (je nach Zerfallsgesetzt, siehe gleich), daher ist es sinnvoll, diese mehreren Echosignale mit einer Multiecho-Sequenz aufzunehmen. Aus den zu einer gemeinsamen Echozeit bzw. Inversionszeit aufgenommenen Messdaten kann je ein Bilddatensatz erstellt werden. Durch ein, insbesondere Bildpunkt-weises, Fitten der erhaltenen Signalwerte der verschiedenen Bilddatensätze an die jeweiligen Zerfallsgesetze (1) bis (3) können die lokalen Werte der Parameter ermittelt werden:

(1) T1-Wert und Protonendichte ρ aus:

$$S = \left| \rho \left( 1 - 2\, exp(-TI/T1) \right) \right| \quad ,$$

mit Inversionszeit TI.
(2) T2-Wert und Protonendichte ρ aus:

$$S = \rho\, exp(-TE/T2) \quad ,$$

mit Echozeit TE.
(3) T2*-Wert und Protonendichte ρ aus:

$$S = \rho\, exp(-TE/T2^*) \quad ,$$

mit Echozeit TE.

Ein Verfahren zur Gewinnung von Protonendichte(ρ)-Karten, T1-Karten, T2-Karten und T2*-Karten unter Verwendung einer Einelschicht-EPI-Sequenz wird von Poupon et al. in "Real-time EPI, T1, T2 and T2* mapping at 3T", Proc. Intl. Soc. Mag. Reson. Med. 18, S. 4983, 2010, beschrieben, bei der hintereinander EPI-Messungen mit jeweils verschiedenen Inversionszeiten, zur Bestimmung von Protonendichte-Karten und T1-Karten (gemäß Zerfallsgesetzt (1)), Spinecho-EPI-Messungen mit jeweils verschiedenen Echozeiten, zur Bestimmung von Protonendichte-Karten und T2-Karten (gemäß Zerfallsgesetzt (2)), und EPI-Messungen mit jeweils verschiedenen Echozeiten, zur Bestimmung von Protonendichte-Karten und T2*-Karten (gemäß Zerfallsgesetzt (3)), jeweils einer Schicht ausgeführt werden, wodurch die Gesamtmesszeit ca. 12 Minuten betrug.

Für T1-Karten ist eine Präparation der erzeugten Echosignale mit entsprechenden RF-Inversionspulsen nötig. Auch für andere Parameter kann eine Präparation der erzeugten Echosignale nötig sein, d.h. die Spins in oder auch um eine zu messende Schicht werden vor der Anregung zur Erzeugung der aufzunehmenden Echosignale mit Hilfe von eingestrahlten RF-Pulsen und/oder geschalteten Gradienten auf eine gewünschte Art und Weise präpariert. Dies ist beispielsweise bei Diffusionsparametern der Fall.

Diffusionsgewichtete Magnetresonanz (MR)-Bilder können in der klinischen Routine wichtige diagnostische Informationen, beispielsweise bei der Schlaganfall- und Tumordiagnostik liefern. Bei der diffusionsgewichteten Bildgebung (DWI) werden zur Präparation Diffusionsgradienten in bestimmten Richtungen geschaltet, wobei die Diffusion von Wassermolekülen entlang des angelegten Diffusionsgradienten das gemessene Magnetresonanzsignal abschwächt. In Gebieten mit geringerer Diffusion erfolgt somit eine geringere Signalabschwächung, sodass diese Gebiete bei einer bildgebenden Magnetresonanztomographie (MRT)- Messung mit höherer Bildintensität abgebildet werden. Die Stärke der Diffusionswichtung ist dabei mit der Stärke der angelegten Diffusionsgradienten korreliert. Die Diffusionswichtung kann mit dem sogenannten b-Wert charakterisiert werden, der eine Funktion von Gradientenparametern ist, wie beispielsweise der Gradientenstärke, Dauer oder des Abstandes zwischen den angelegten Diffusionsgradienten. Die Aufnahme der resultierenden Magnetresonanzsignale erfolgt wegen der Schnelligkeit dieser Sequenzen meist mit einer Multiecho-Sequenz, wie beispielsweise EPI.

Bei der Diffusionsbildgebung werden in der Regel mehrere Bilder mit unterschiedlichen Diffusionsrichtungen und- wichtungen (gekennzeichnet durch den b-Wert) aufgenommen und miteinander kombiniert, um beispielsweise Diffusionsparameterkarten, insbesondere der Diffusionsparameter "Apparent Diffusion Coefficient" (ADC) und/oder "Fractional Anisotropy" (FA), zu berechnen. In dem Review-Artikel von Dietrich et al., "Technical aspects of MR diffusion imaging of the body", European Journal of Radiology 76, S. 314-322, 2010, wird ein Überblick über bekannte DWI-Verfahren gegeben.

Wie oben ausgeführt, ermöglichen Schichtmultiplexing-Verfahren die Messung von Echosignalen aus zwei oder mehr Schichten simultan, innerhalb einer Messdatenaufnahme. Dadurch kann bei Multiecho-Verfahren, bei welchen nach einer ersten Anregung von Spins von diesen durch Einstrahlen von RF-Pulsen und/oder Schalten von Gradienten mehrere Echosignale erzeugt und aufgenommen werden, im Vergleich zu Einzelschicht-Messungen die minimale Wiederholzeit TR verkürzt werden, die für die Aufnahme aller gewünschter Echosignale nach einer ersten Anregung benötigt wird, da weniger Echosignale erzeugt werden müssen, wenn diese aus mehreren Schichten gleichzeitig aufgenommen werden als wenn in jedem aufgenommenen Echosignal nur Messdaten einer einzelnen Schicht enthalten sind. Beispielsweise, wenn aus n Schichten Messdaten simultan gemessen werden, reduziert sich die zur Aufnahme der gewünschten Echosignale aller Schichten benötigte Zeit um den Faktor n.

Allerdings wird die minimale Wiederholzeit TR in vielen MR-Anwendungen nicht durch die Zeit bestimmt, die benötigt wird, um alle gewünschten Echosignale nach einer Anregung aufzunehmen, sondern ist von dem jeweils gewünschten Bildkontrast abhängig. Soll ein gemäß der T1-, der T2- oder der T2*-Zerfallskonstanten des jeweils abgebildeten Gewebes gewichteter Kontrast erreicht werden, muss die Wiederholzeit TR ausreichend sein, um die gewünschten Zerfallsvorgänge abbilden zu können, da ansonsten der gewünschte Bildkontrast nicht in ausreichender Qualität aus den Messdaten ermittelbar ist. Daher bringen die bekannten Schichtmultiplexing-Verfahren keinen Zeitvorteil bei Multiecho-Verfahren, die MR-Bilder mit einem bestimmten Kontrast erzeugen sollen.

In der US20170108567A1, sowie den nachveröffentlichten US-Patentanmeldungen 15/139,732, 15/218,388 und 15/221,635 sind bereits Verfahren beschrieben, wie mittels Schichtmultiplexing-Verfahren Messdaten aufgenommen werden können, aus welchen MR-Bilder mit unterschiedlichen Kontrastwichtungen erstellt werden können. Ein weiteres derartiges Verfahren ist in dem Artikel "Simultaneous Multi-Contrast Imaging with ReadoutSegmented EPI", Proc. Intl. Soc. Mag. Reson. Med. 25, S. 520, 2017 von Breutigam et al. beschrieben.

Mit den genannten Verfahren ist es jedoch weiter nicht möglich Messdaten in möglichst kurzer Zeit aufzunehmen, aus welchen unterschiedliche Parameterkarten bestimmt werden können.

Der Erfindung liegt daher die Aufgabe zugrunde, in klinisch akzeptabel kurzer Zeit Aufnahmen von MR-Messdaten zu ermöglichen, aus welchen MR-Bilder mit unterschiedlichen Kontrastwichtungen und unterschiedliche Parameterkarten eines Untersuchungsobjekts erstellt werden können.

Die Aufgabe wird gelöst durch ein Verfahren zur Erzeugung von unterschiedlich kontrastgewichteten Messdaten eines Untersuchungsobjektes mittels Magnetresonanztechnik gemäß Anspruch 1, eine Magnetresonanzanlage gemäß Anspruch 11. ein Computerprogramm gemäß Anspruch 12 sowie einen elektronisch lesbaren Datenträger gemäß Anspruch 13.

Ein erfindungsgemäßes Verfahren zur Erzeugung von unterschiedlich kontrastgewichteten Messdaten eines Untersuchungsobjektes mittels Magnetresonanztechnik umfasst die Schritte:

a) Wählen einer Anzahl (N) von verschiedenen zu messenden Schichten ($S_1$ ... $S_N$), einer Anzahl von gewünschten ersten Kontrastierungsmessparametern zur Erzeugung von mit einem gewünschten ersten Kontrast gewichteten Messdaten und jeweils einer weiteren Anzahl von gewünschten zweiten Kontrastierungsparametern zur Erzeugung von mit zumindest einem zweiten Kontrast gewichteten Messdaten, wobei der erste Kontrast und die zweiten Kontraste jeweils verschieden sind,
b) Anregen einer Schicht der zu messenden Schichten ($S_1$ ... $S_N$) unter Verwendung eines ersten Kontrastierungsmessparameters,

c) Anregen zumindest einer anderen Schicht der zu messenden Schichten ($S_1$ ... $S_N$) unter Verwendung eines zweiten Kontrastierungsmessparameters,
d) Aufnehmen von erzeugten Echosignalen der angeregten Schichten ($S_i$, $S_j$) als Messdaten und Speichern der Messdaten in einem Messdatensatz ($MD_{imjk}$),
e) Wiederholen der Schritte b) bis d) unter Verwendung von unterschiedlichen ersten Kontrastierungsmessparametern der gewünschten ersten Kontrastierungsparameter und unter Verwendung von unterschiedlichen zweiten Kontrastierungsmessparametern der gewünschten zweiten Kontrastierungsparameter bis alle zu messenden Schichten ($S_1$ ... $S_N$) zumindest einmal mit jedem gewünschten ersten Kontrastierungsmessparameter und zumindest einmal mit jedem gewünschten zweiten Kontrastierungsmessparameter angeregt wurden, und die dabei erzeugten Echosignale in einem Messdatensatz ($MD_{imjk}$) gespeichert wurden, dadurch gekennzeichnet, dass in Schritt c) zumindest eine erste zweite Schicht unter Verwendung eines ersten zweiten Kontrastierungsmessparameters und eine zweite zweite Schicht unter Verwendung eines zweiten zweiten, von dem ersten zweiten Kontrastierungsparameter verschiedenen, Kontrastierungsparameters als zumindest eine andere Schicht angeregt werden, wobei die eine in Schritt b) angeregte Schicht und die in Schritt c) angeregten erste zweite Schicht und zweite zweite Schicht jeweils verschieden sind, und wobei in den angeregten Schichten erzeugte Echosignale in je einer der angeregten Schichten als inversionspräparierte Echosignale, als Gradientenechosignale und als Spinechosignale erzeugt werden.

Durch die erfindungsgemäße wiederholt durchgeführte Anregung zur Erzeugung von Echosignalen und Aufnahme der erzeugten Echosignale in zumindest zwei verschiedenen Schichten, wobei innerhalb einer Wiederholung einer Anregung zur Erzeugung von Echosignalen und Aufnahme der erzeugten Echosignale eine der zumindest zwei Schichten unter Verwendung verschiedener gewünschter erster Kontrastierungsmessparameter zur Erzeugung von mit einem ersten Kontrast gewichteten Messdaten angeregt wird, und zumindest eine andere der zumindest zwei Schichten unter Verwendung verschiedener gewünschter zweiter Kontrastierungsmessparameter zur Erzeugung von mit einem zweiten Kontrast gewichteten Messdaten angeregt wird, werden mit jeder Wiederholung gemäß unterschiedlicher Kontraste gewichtete Messdaten erzeugt. Durch die Variation der Kontrastierungsparameter der jeweils erzeugten Kontraste, enthalten die insgesamt aufgenommenen Messdaten unterschiedliche Informationen über das untersuchte Untersuchungsobjekt. Beispielsweise können Parameterkarten von in dem Untersuchungsobjekt vorliegende Materie charakterisierenden Parametern, wie Protonendichte oder von den gewählten Kontrasten abhängige Zerfallskonstanten bestimmt werden. Damit kann im Rahme der erfindungsgemä-ßen Erzeugung von unterschiedlich kontrastgewichteten Messdaten in kurzer Aufnahmezeit eine Vielzahl an, auch quantitativer, Information über das Untersuchungsobjekt gewonnen werden, was insbesondere für eine medizinische Diagnose wertvoll ist.

Als gewünschte Kontrastierungsparameter kommen insbesondere die im Rahmen der Anregung und Aufnahme von Echosignalen einer Schicht realisierten Echozeiten in Frage, sodass in jeder Wiederholung zumindest eine Schicht derart angeregt werden kann, dass eine Echozeit einer Anzahl an gewünschten Echozeiten realisiert wird. Auf diese Weise können gemäß einem transversalen Zerfall T2 oder T2* gewichtete Messdaten aufgenommen werden, aus welchen (durch die wiederholte Aufnahme mit unterschiedlichen Echozeiten) die Verteilung der Zerfallskonstanten T2 oder T2* in den gemessenen Schichten ermittelt werden kann. Soll ein T2-Kontrast erreicht werden, sind die Echosignale als Spinechosignale zu erzeugen. Soll ein T2*-Kontrast erreicht werden, sind die Echosignale als Gradientenechosignale zu erzeugen. Dies kann jeweils auch in den Kontrastierungsparametern festgelegt werden.

Als gewünschte Kontrastierungsparameter kommen auch gewünschte Präparationen in Frage, sodass in jeder Wiederholung eine Schicht der zu messenden Schichten unter Verwendung einer Präparation der gewünschten Präparationen angeregt wird. Auf diese Weise können Messdaten erhalten werden, die gemäß zu präparierender Kontraste, wie z.B. T1-Kontrast, Diffusionskontraste usw., gewichtet sind.

Es können somit innerhalb einer Wiederholung einer Anregung zur Erzeugung von Echosignalen in einer ersten und in mindestens einer zweiten Schicht und Aufnahme der erzeugten Echosignale in der ersten und der mindestens einen zweiten Schicht die in der ersten Schicht erzeugten Echosignale durch eine Präparation aus einer Anzahl gewünschter verschiedener Präparationen präpariert werden, während die in der mindestens einen zweiten Schicht erzeugten Echosignale nach einer Echozeit aus einer Anzahl gewünschter verschiedener Echozeiten erzeugt werden können. Derartige Wiederholungen können unter Verwendung der verschiedenen gewünschten Präparationen und unter Realisierung der verschiedenen gewünschten Echozeiten wiederholt werden, sodass jeweils in einer Wiederholung präparationsgeprägte Echosignale aus einer Schicht und durch eine bestimmte Echozeit geprägte Echosignale aus zumindest einer anderen Schicht aufgenommen und als Messdatensätze gespeichert werden können.

Durch eine derartige Anregung einer ersten Schicht unter Verwendung einer ersten Präparation verschiedener gewünschter Präparationen und der Anregung zumindest einer zweiten Schicht unter Realisierung einer Echozeit verschiedener gewünschter Echozeiten in einem gemeinsamen Zeitfenster und das Wiederholen der genannten Anregungen erster und zweiter Schichten mit jeweils unterschiedlichen Präparationen der gewünschten Präparationen und unter Realisierung von jeweils unterschiedlichen Echozeiten der gewünschten Echozeiten, werden innerhalb eines Messgangs Messdatensätze für alle gewünschten Schichten erstellt, welche nicht nur gemäß der gewünschten Präparation geprägt sind, sondern auch Messdatensätze der gewünschten Schichten, welche gemäß der gewünschten Echozeiten eine unterschiedlich starke Wichtung bezüglich eines transversalen Zerfalls der Anregung der Spins aufweisen. Dadurch wird eine gegenüber bekannten Aufnahmeverfahren stark beschleunigte Aufnahme von Messdaten mit dennoch erhöhtem Informationsgehalt ohne Qualitätseinbußen ermöglicht.

Aus den auf diese Weise beschleunigt aufgenommenen Messdaten können somit nicht nur gemäß der gewünschten Präparation gewichtete Bilddaten erstellt werden, sondern zusätzlich (aus den Messdatensätzen der unterschiedlichen Echozeiten) quantitative Parameterkarten erstellt werden, welche weitere wichtige Informationen, insbesondere für die klinische Diagnostik, liefern.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung mit einer Präparations-/Echozeiteinheit. Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:

Fig. 1 ein schematisches Ablaufdiagramm eines Verfahrens, das nicht alle Merkmale des Anspruchs 1 umfasst und somit nicht in den Schutzumfang der Erfindung fällt,

Fig. 2 ein vereinfachtes schematisches Schaltdiagramm einer Wiederholung, wobei die Wiederholung nicht alle Merkmale des Anspruchs 1 umfasst und somit nicht in den Schutzumfang der Erfindung fällt,

Fig. 3 ein Schaltdiagramm einer denkbaren Wiederholung, die nicht in den Schutzumfang der Erfindung fällt,

Fig. 4-6 erfindungsgemäße Schaltdiagramme denkbarer Wiederholungen,

Fig. 7 eine schematische Darstellung einer erfindungsgemä-ßen Magnetresonanzanlage.

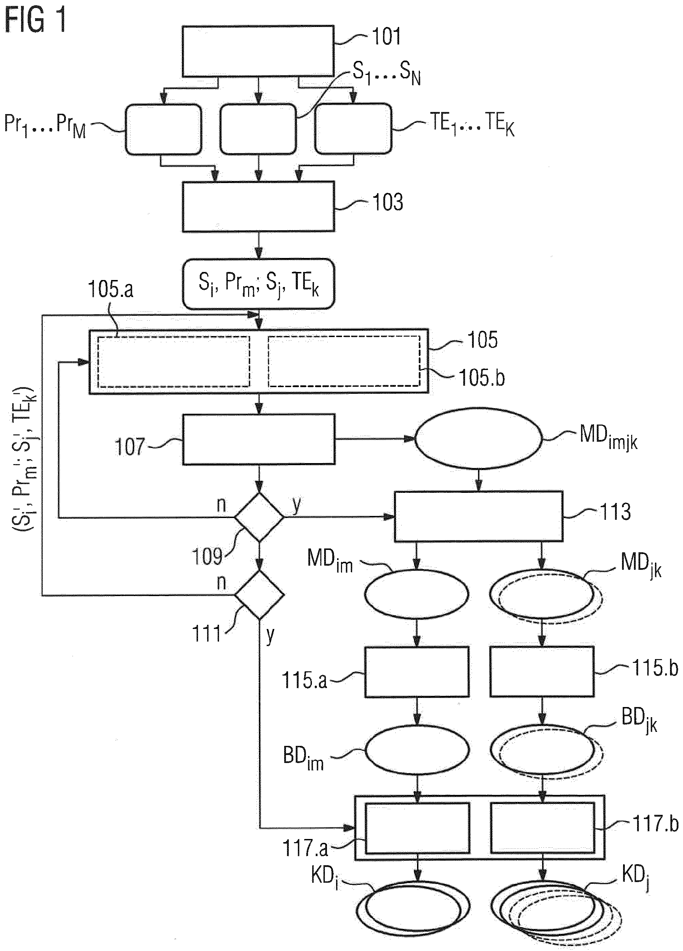

Figur 1 ist ein schematisches Ablaufdiagramm eines Verfahrens zur Erzeugung von unterschiedlich kontrastgewichteten Messdaten eines Untersuchungsobjektes mittels Magnetresonanztechnik.

Dabei werden eine Anzahl N verschiedene zu messende Schichten $S_1 ... S_N$ und eine Anzahl von gewünschten ersten Kontrastierungsmessparametern zur Erzeugung von mit einem gewünschten ersten Kontrast gewichteten Messdaten und jeweils eine weitere Anzahl von gewünschten zweiten Kontrastierungsparametern zur Erzeugung von mit zumindest einem zweiten Kontrast gewichteten Messdaten gewählt (Block 101). Der erste Kontrast und zweite Kontraste sind hierbei jeweils verschieden und können aus einer Gruppe von Kontrasten gewählt sein, die insbesondere T1-Kontrast, T2-Kontrast und T2*-Kontrast umfassen. Gewünschte Kontrastierungsmessparameter können hierbei gewünschte Echozeiten $TE_1 ... TE_K$ sein, die in Wiederholungen einer Anregung zur Erzeugung von Echosignalen und Aufnahme der erzeugten Echosignale einer Schicht $S_j$ der zu messenden Schichten $S_1 ... S_N$ realisiert werden sollen.

Gewünschte Kontrastierungsmessparameter können hierbei gewünschte Präparationen $Pr_1 ... Pr_M$ sein, welche in Wiederholungen einer Anregung zur Erzeugung von Echosignalen einer Schicht $S_i$ der zu messenden Schichten $S_1 ... S_N$ verwendet werden sollen.

Insbesondere können somit eine Anzahl M verschiedene gewünschte Präparationen $Pr_1 ... Pr_M$ und eine Anzahl K verschiedene gewünschte Echozeiten $TE_1 ... TE_K$ gewählt werden.

Die gewählten Schichten überschneiden sich nicht, sondern liegen beispielsweise parallel nebeneinander im zu untersuchenden Untersuchungsobjekt, und decken den abzubildenden Bereich (ROI, engl. "region of interest") in dem Untersuchungsobjekt auf eine gewünschte Art und Weise ab. Die Anzahl N der zu messenden Schichten ist hierbei mindestens gleich 2, damit im Verlauf eine erste Schicht und zumindest eine andere Schicht aus den N Schichten gewählt werden kann, die jeweils mit Kontrastierungsparametern verschiedener Kontraste angeregt und aus denen Messdaten aufgenommen werden können. Die Anzahl N der Schichten ist insbesondere gleich der Anzahl an verschiedenen gewünschten Kontrasten. Dadurch können in einer Wiederholung einer Anregung zur Erzeugung von Echosignalen und Aufnahme der erzeugten Echosignale Messdaten zu je einem aller gewünschter Kontraste aus jeweils einer anderen Schicht gewonnen werden. Eine Wiederholung liefert somit Messdaten zu jedem gewünschten Kontrast (wenn auch zu unterschiedlichen Schichten). Werden beispielsweise nur zwei verschiedene Kontraste gewünscht, beispielsweise T1- und T2-Kontrast, oder T1- und T2*-Kontrast, oder T2- und T2*-Kontrast, zu denen Messdaten mit jeweils unterschiedlichen Kontrastierungsparametern gewonnen werden sollen, ist es ausreichend eine Anzahl N=2 Schichten pro Wiederholung auszuwählen.

Eine Anzahl M gewünschter Präparationen ist mindestens gleich Eins, sodass zumindest eine Präparation der Spins in einer ersten Schicht vor dem Aufnehmen der so präparierten Echosignale erfolgt. Die Anregung und Aufnahme von Echosignalen unter Verwendung einer Präparation erfolgt stets mit derselben Echozeit.

Als gewünschte Präparationen kommen beispielsweise Präparationen eines Präparationstyps aus der Gruppe von Präparationstypen, welche zumindest einen RF-Inversionspuls umfassen, in Frage. Mit einer Präparation mittels zumindest eines RF-Inversionspulses kann z.B. eine T1-Präparation oder eine Unterdrückungspräparation unerwünschter Signale (z.B. durch spektral selektive RF-Inversionspulse) oder auch ASL-Präparationen (ASL: "arterial spin labeling") erreicht werden. Die hierbei verwendeten RF-Inversionspulse werden eine Inversionszeit genannte Zeitdauer vor einem RF-Anregungspuls derart eingestrahlt, dass sie eine Wirkung auf die in der zu messenden Schicht aufgenommenen Echosignale haben. Verschiedene gewünschte Präparationen $Pr_1 ... Pr_M$ können sich somit in der verwendeten Inversionszeit als Präparationswert unterscheiden.

Die gewünschten Präparationen können aber auch von einem Präparationstyp sein, welcher zumindest einen RF-Magnetisierungstransferpuls umfasst. Mittels RF-Magnetisierungstransferpulsen kann eine Magnetisierungstransferpräparation erreicht werden, mit der bestimmte in dem ROI liegende Materie (Gewebetypen) unterdrückt wird, wodurch andere Materie deutlicher sichtbar wird. Verschiedene gewünschte Präparationen $Pr_1 ... Pr_M$ können sich somit in der verwendeten spektralen Selektivität als Präparationswert unterscheiden.

Die gewünschten Präparationen können aber auch Präparationen eines Diffusions-Präparationstyps sein. Verschiedene gewünschte Präparationen $Pr_1 ...$ $Pr_M$ können sich somit in der verwendeten Diffusionswerten (b-Werten) und/oder in den verwendeten Diffusionsrichtungen als Präparationswert unterscheiden. Umfassen die gewünschten Präparationen mindestens zwei unterschiedliche Diffusionswerte (b-Wert) und/oder Diffusionsrichtungen als Präparationswerte, können Diffusionsparameterkarten erstellt werden.

Werden mindestens zwei unterschiedliche Präparationen eines Präparationstyps gewählt, können grundsätzlich aus den jeweils mit einem anderen Präparationswert aufgenommenen Messdatensätzen quantitative Parameterkarten von aus der durch die Präparation aufgeprägten Gewichtungen ableitbaren Parametern gewonnen werden. Die Anregung und Aufnahme von Echosignalen unter Verwendung verschiedener Präparationen erfolgt aber auch dann stets mit derselben Echozeit, damit sich die mit verschiedenen Präparationen aufgenommenen Messdaten der ersten Schichten möglichst nur in der verschiedenen Präparation unterscheiden.

Eine Anzahl K verschiedener gewünschter Echozeiten $TE_1$ ... $TE_K$ für die Aufnahme von Messdaten aus mindestens einer (zweiten) Schicht ist mindestens gleich 2, damit der durch die Echozeit abhängige Parameter des transversalen Magnetisierungszerfalls untersucht werden kann. Ob der T2-Zerfall oder der T2*-Zerfall aus den mit den K verschiedenen Echoszeiten aufgenommenen Messdatensätzen bestimmt werden kann, richtet sich insbesondere nach der während der Anregung einer zweiten Schicht vorgenommenen Manipulation der Spins. Umfasst die Anregung einer zweiten Schicht einen Refokussierungspuls zur Erzeugung von Spinechosignalen, wird der T2-Zerfall bestimmt. Werden durch die Anregungen einer zweiten Schicht Gradientenechosignale erzeugt, wird der T2*-Zerfall bestimmt.

Bei der Wahl der gewünschten Echozeiten $TE_1$ ... $TE_K$ kann berücksichtigt werden, dass grundsätzlich zwei verschiedene Echozeiten $TE_k$ ausreichen, um transversale Zerfallskonstanten bestimmen zu können, dass aber die Bestimmung genauer erfolgen kann, einerseits wenn die verschiedenen Echozeiten $TE_k$ einen ausreichenden zeitlichen Abstand voneinander aufweisen und andererseits je mehr verschiedene Echozeiten $TE_k$ gemessen werden, d.h. desto größer die Anzahl K ist. Denn eine größere Anzahl an an das zugehörige Zerfallsgesetz anzufittender Werte verbessert das Ergebnis des Fits.

Nach einer Wahl 101 N verschiedener zu messenden Schichten $S_1$ ... $S_N$, M verschiedener gewünschter Präparationen $Pr_1$ ... $Pr_M$ und K verschiedener gewünschter Echozeiten $TE_1$ ... $TE_K$ können die jeweils in einer Wiederholung mit einer Präparation $Pr_m$ zu messende ersten Schichten $S_i$ und in derselben Wiederholung mit Echozeiten $TE_k$ zu messende, je Wiederholung zumindest eine, zweite Schichten $S_j$ bestimmt werden (Block 103).

Eine Wiederholung wird durch Anregung von Echosignalen gestartet (Block 105). Dabei wird eine erste Schicht $S_i$ der N zu messenden Schichten unter Verwendung einer Präparation $Pr_m$ der gewünschten Präparationen $Pr_1$ ... $Pr_M$ angeregt (Block 105.a) und zumindest eine zweite Schicht $S_j$ der N zu messenden Schichten, wobei $S_i \neq S_j$ ist, derart angeregt, dass eine Echozeit $TE_k$ der gewünschten Echozeiten $TE_1$ ... $TE_K$ realisiert wird (Block 105.b).

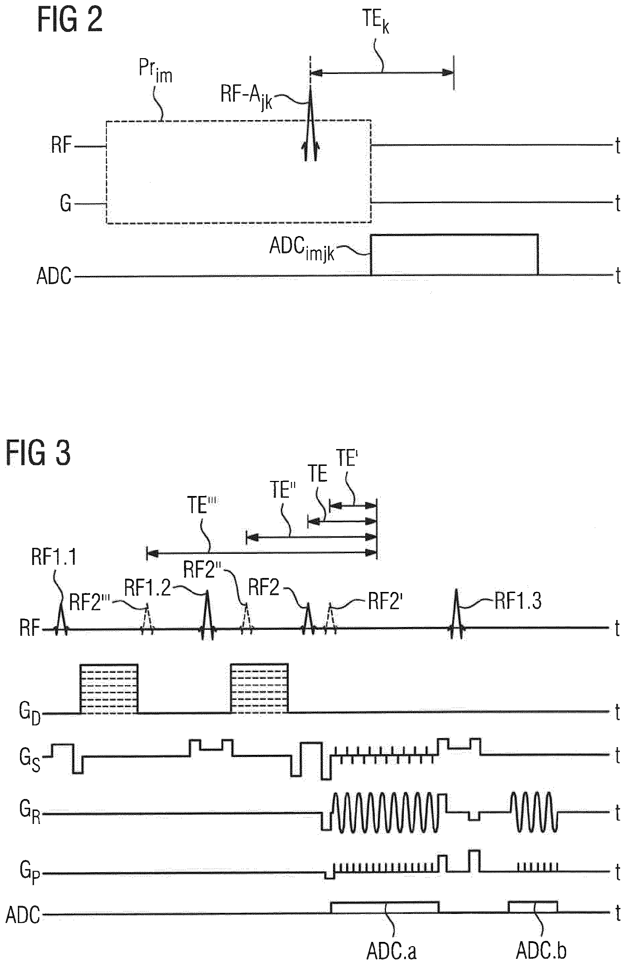

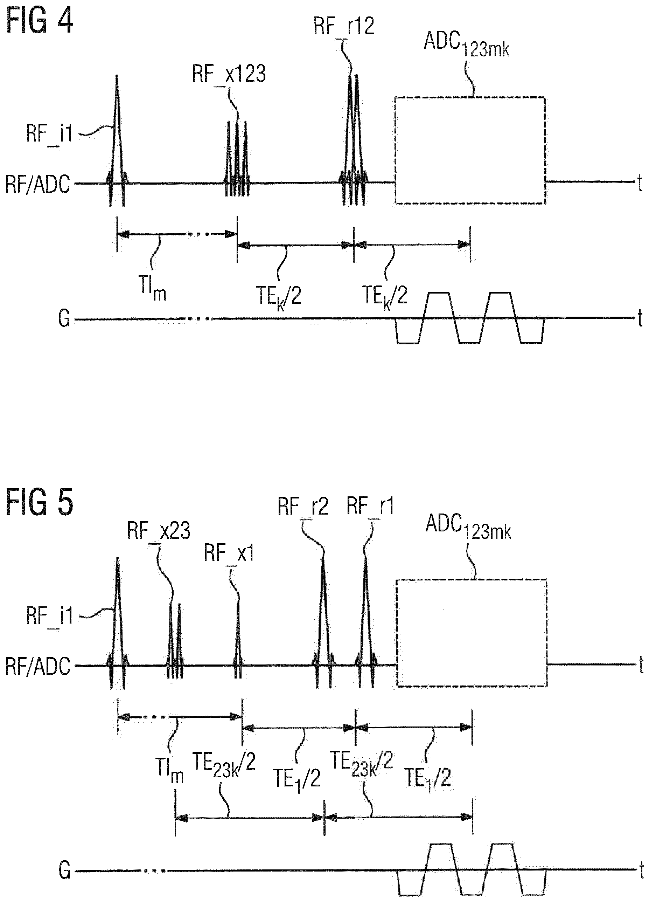

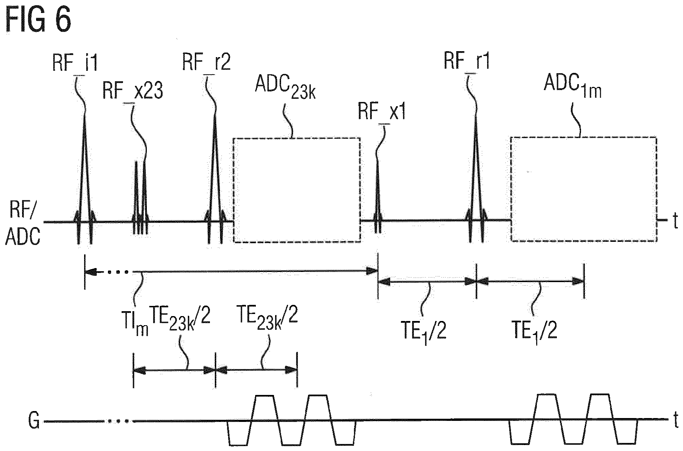

Ein mögliches stark vereinfachtes Schaltdiagramm einer möglichen derartigen Wiederholung ist grob schematisch in Figur 2 im Verlauf der Zeit t dargestellt. Für die Anregung der ersten Schicht $S_i$ werden im Rahmen der gewünschten Präparation $Pr_{im}$ für die erste Schicht $S_i$ RF-Pulse eingestrahlt und Gradienten G geschaltet, um Echosignale in der ersten Schicht $S_i$ zu erzeugen, die in zumindest einem Ausleseschritt $ADC_{imjk}$ aufgenommen werden. Um Echosignale in mindestens einer zweiten Schicht $S_j$ zu erzeugen, wird mindestens ein zumindest in der jeweiligen zweiten Schicht $S_j$ wirkender RF-Anregungspuls $RF\text{-}A_{jk}$ derart eingestrahlt, dass in der (jeweiligen) zweiten Schicht $S_j$ Echosignale erzeugt werden, die nach einer Echozeit $TE_k$ nach dem RF-Anregungspuls $RF\text{-}A_{jk}$ in beispielsweise demselben Ausleseschritt $ADC_{imjk}$ aufgenommen werden. Eine Wiederholung kann derart gestaltet sein, dass in dem Ausleseschritt $ADC_{imjk}$ die erzeugten Echosignale aller angeregten Schichten $S_i$ und $S_j$ gleichzeitig aufgenommen werden. Es ist auch denkbar, dass die Echosignale der verschiedenen Schichten $S_i$ und $S_j$ zumindest in einigen Wiederholungen in getrennten Ausleseschritten aufgenommen werden (siehe z.B. Figur 6). Die Echozeit $TE_k$ kann somit insbesondere durch Variieren des Zeitpunktes, zu welchem der RF-Anregungspuls $RF\text{-}A_{jk}$ eingestrahlt wird (Startpunkt der Echozeit, gestrichelt dargestellt), verändert werden. Beispiele von möglichen Schaltdiagrammen erfindungsgemäßer Wiederholungen werden weiter unten mit Bezug auf die Figuren 4 bis 6 beschrieben.

In mindestens einer Wiederholung kann das Anregen 105.a der ersten Schicht $S_i$ und das Anregen 105.b der zumindest einen zweiten Schicht $S_j$ derart erfolgen, dass Echosignale aus der ersten Schicht $S_i$ und aus der zumindest einen zweiten Schicht $S_j$ simultan erzeugt und kollabiert in einem Messdatensatz $MD_{imjk}$ gespeichert werden.

Weiterhin kann in mindestens einer Wiederholung das Anregen 105 der ersten und zweiten Schichten $S_i$ und $S_j$ zumindest einen Multi-Band-RF-Puls umfassen, welcher zumindest zwei der ersten und zweiten Schichten $S_i$ und $S_j$ gleichzeitig manipuliert. Hierbei kommen insbesondere RF-Anregungspulse oder RF-Refokussierungspulse in Frage, die in zumindest zweien der ersten und zweiten Schichten $S_i$ und $S_j$ wirken. Einige Beispiele sind weiter unten in Bezug auf die Figuren 4 bis 6 gegeben.

Die in der Wiederholung erzeugten Echosignale der ersten und der zumindest einen zweiten Schicht $S_i$ und $S_j$ werden als Messdaten aufgenommen (Block 107) und die Messdaten in einem Messdatensatz $MD_{imk}$ gespeichert.

Werden in einer Wiederholung nicht alle Messdaten der ersten und der mindestens einen zweiten Schicht $S_i$ und $S_j$ aufgenommen (wird also bei der Aufnahme der Messdaten keine "single shot"-Sequenz, sondern z.B. eine segmentierte Multiecho-Sequenz verwendet), kann geprüft werden, ob bereits alle Messdaten der ersten Schicht $S_i$ und der zumindest einen zweiten Schicht $S_j$ aufgenommen wurden (Abfrage 109). Sind noch nicht alle Messdaten der ersten und der mindestens einen zweiten Schicht $S_i$ und $S_j$ mit der Präparation $Pr_m$ und der Echozeit $TE_k$ aufgenommen (Abfrage 109, n), so kann die Anregung 105 von Echosignalen und die Aufnahme 107 von Messdaten mit geänderten Kodierungsgradienten wiederholt werden, bis alle gewünschten Messdaten der ersten und der mindestens einen zweiten Schicht $S_i$ und $S_j$ mit der Präparation $Pr_m$ und der Echozeit $TE_k$ aufgenommen sind.

Weiterhin kann geprüft werden, ob bereits Messdaten aller zu messender Schichten $S_1$ ... $S_N$ mit allen gewünschten Präparationen $Pr_1$ ... $Pr_m$ und allen gewünschten Echozeiten $TE_1$ ... $TE_K$ durchgeführt wurden (Abfrage 111). Ist dies nicht der Fall (Abfrage 111, n), wird die Anregung 105 von Echosignalen und die Aufnahme 107 von Messdaten mit einer geänderten (noch fehlenden) Präparation $PR_m$' für eine (ggf. geänderte) erste Schicht $S_i$' und/oder mit einer geänderten (noch fehlenden) Echozeit $TE_k$' für zumindest eine (ggf. geänderte) zweite Schicht $Sj$' wiederholt.

Die Anregung 105 der Echosignale in den ersten und zweiten Schichten $S_i$ und $S_j$ und die Aufnahme 107 der erzeugten Echosignale wird somit unter Verwendung von unterschiedlichen Präparationen $Pr_m$ der gewünschten Präparationen $Pr_1$ ... $PR_M$ bei Anregung 105.a der ersten Schichten $S_j$ und unter Realisierung von unterschiedlichen Echozeiten $TE_k$ der gewünschten Echozeiten $TE_1$ ... $TE_K$ bei Anregung 105.b der zweiten Schichten $S_j$ solange wiederholt bis alle zu messenden Schichten $S_1$ ... $S_N$ zumindest einmal mit jeder gewünschten Präparation $Pr_1$ ... $PR_M$ und zumindest einmal mit jeder gewünschten Echozeit $TE_1$ ... $TE_K$ angeregt wurden, und die dabei erzeugten Echosignale in einem Messdatensatz $MD_{imjk}$ gespeichert wurden.

Bei der Abfrage 111 kann auch berücksichtigt werden, dass gegebenenfalls Messdaten einer Schicht $S_i$ und/oder $S_j$ in mehreren Wiederholungen mit derselben Präparation $Pr_m$ bzw. mit derselben Echozeit $TE_k$ aufgenommen werden sollen, sei es, weil dies gezielt gewünscht wird, um z.B. das erreichte Signal-zu-Rausch-Verhältnis (SNR, engl. "signal to noise ratio") zu verbessern oder eine Bewegungs- und/oder Flusssensitivität der Messung zu verringern, oder weil z.B. mehr verschiedene Präparationen $Pr_1$ ... $Pr_M$ als verschiedene Echozeiten $TE_1$ ... $TE_K$ gewünscht werden (also M>K) und daher Messdaten gewählter Echozeiten $TE_k$ mehrfach aufgenommen werden können, oder analog andersherum (K>M).

Die Abfrage 109 muss hierbei nicht zwingend vor der Abfrage 111 geprüft werden, sondern es können auch z.B. segmentierte Aufnahmen nur eines Teils der Messdaten von verschiedenen Schichten $S_i$, $S_j$, $Si$' $S_j$' nacheinander durchgeführt werden. Dies kann sinnvoll sein, wenn die Reihenfolge der insgesamt durchzuführenden Wiederholungen der Aufnahme 105 von Messdaten möglichst frei gestaltbar sein soll, z.B. um eine Belastung auf das Gradientensystem und/oder die RF-Antennen möglichst gering gestalten zu können.

Sind alle Messdaten der ersten und der mindestens einen zweiten Schicht $S_i$ und $S_j$ mit einer Präparation $Pr_m$ und einer Echozeit $TE_k$ aufgenommen (Abfrage 109, y), kann aus dem gespeicherten Messdatensatz $MD_{imjk}$ ein gemäß der Präparation $PR_m$ präparierter Messdatensatz $MD_{im}$ der Schicht $S_i$ und je zweiter angeregter Schicht $S_j$ ein gemäß der Echozeit $TE_k$ nach einem transversalen Zerfall gewichteter Messdatensatz $MD_{jk}$ der jeweiligen Schicht j erstellt werden (Block 113). Ob es sich bei dem Messdatensatz $MD_{jk}$ um einen T2-gewichteten oder um einen T2*-gewichteten Messdatensatz handelt, hängt von der bei der Anregung 105 von Echosignalen und der Aufnahme 107 von Messdaten verwendeten Sequenzart ab. Wurden Spinechos erzeugt und aufgenommen, kann ein T2-gewichteter Messdatensatz $MD_{jk}$ erstellt werden. Wurden Gradientenechos erzeugt und aufgenommen, kann ein T2*-gewichteter Messdatensatz $MD_{jk}$ erstellt werden. Es ist auch denkbar in Wiederholungen 105 sowohl Gradientenechosignale als auch Spinechosignale, z.B. in unterschiedlichen zweiten Schichten $S_j$, zu erzeugen. Ein derartiges Beispiel wird weiter unten mit Bezug auf die Figuren 4 bis 6 beschrieben.

Liegen die Messdaten der Schichten $S_i$ und $S_j$ in dem Messdatensatz $MD_{imjk}$ bereits getrennt nach den einzelnen Schichten $S_i$ und $S_j$ vor, so können die Messdatensätze $MD_{im}$ und $MD_{jk}$ ohne weiteres erstellt werden. Liegen Messdaten der Schichten $S_i$ und $S_j$ in dem Messdatensatz $MD_{imjk}$ kollabiert vor, so kann die Erstellung der Messdatensätze $MD_{im}$ und $MD_{jk}$ eine Trennung des kollabierten Messdatensatzes $MD_{imjk}$ in die jeweils nur noch Messdaten der einzelnen Schichten (Einzelschicht-Messdaten) enthaltenden Messdatensätze $MD_{im}$ und $MD_{jk}$ umfassen. Dies kann unter Verwendung einer parallelen Akquisitionstechnik, beispielsweise unter Verwendung von aus Schichtmultiplexing-Verfahren bekannten Techniken, insbesondere einer slice-GRAPPA-Technik, erfolgen.

Auf Basis der gespeicherten Messdatensätze $MD_{imjk}$ können gemäß der jeweiligen Echozeit $TE_k$ und/oder der jeweiligen Präparation $Pr_m$ gewichtete Bilddaten $MD_{im}$ und/oder $MD_{jk}$ rekonstruiert werden. Die Rekonstruktion der Bilddaten kann auf übliche Weise erfolgen und insbesondere eine Fouriertransformation umfassen.

Dazu können aus den erstellten Messdatensätzen $MD_{im}$ Bilddaten $BD_{im}$ rekonstruiert werden (Block 115.a), die gemäß der Präparation $Pr_m$ gewichtet sind. Aus den erstellten Messdatensätzen $MD_{jk}$ können wiederum Bilddaten $BD_{jk}$ rekonstruiert werden (Block 115.b), die gemäß der Echozeit $TE_k$ und der Art der zugrundeliegenden aufgenommenen Echosignale T2- oder T2*-gewichtet sind.

Sind alle Messdaten (Abfrage 109, y) aller zu messender Schichten $S_1 ... S_N$ mit allen gewünschten Präparationen $Pr_1 ... Pr_M$ und allen gewünschten Echozeiten $TE_1 ... TE_K$ aufgenommen (Abfrage 111, y), so kann die Aufnahme von Messdaten beendet werden und zu jedem gespeicherten Messdatensatz $MD_{imjk}$ anhand der Blöcke 113, 115.a und 115.b beschrieben ein präparationsgewichteter Bilddatensatz $BD_{im}$ und zumindest ein gemäß einen transversalen Zerfall (T2 oder T2*) gewichteter Bilddatensatz $BD_{jk}$ rekonstruiert werden.

Durch das Verfahren erhält man Messdaten zu jedem gewünschten Kontrast mit jeweils unterschiedlichen Kontrastierungsparametern. Aus mit verschiedenen Kontrastierungsparametern aufgenommenen Messdatensätzen können jeweils den verschiedenen Kontrastierungsparametern zugehörige Bilddaten eines gewünschten Kontrasts rekonstruiert werden. Aus verschiedenen Kontrastierungsparametern zugehörigen z.B. eine Schicht in einem Untersuchungsobjekt darstellenden Bilddaten eines gewünschten Kontrasts kann zumindest eine Parameterkarte eines in dem Untersuchungsobjekt vorliegende Materie charakterisierenden Parameters, insbesondere eines gewebetypischen Parameters, bestimmt werden. Dies kann z.B. durch (bildpunktweises) Vergleichen der Bilddaten der jeweils verschiedenen Kontrastierungsparameter mit über die gesuchten Parameter bekannten Gesetzmäßigkeiten, insbesondere unter Anwendung eines Fits, erfolgen.

Aus zumindest zwei unterschiedlich präparationsgewichteten Bilddaten $BD_{im}$ einer Schicht $S_i$, und somit auf Basis von aufgenommenen Messdaten $MD_{imjk}$, kann auf bekannte Art und Weise eine Parameterkarte $KD_i$ eines in dem Untersuchungsobjekt in der Schicht $S_i$ vorliegende Materie charakterisierenden Parameters bestimmt werden (Block 117.a). Als Parameter, deren Verteilung in der Schicht $S_i$ aus unterschiedlich präparationsgewichteten Bilddaten $BD_{im}$ bestimmt werden können, sind in Abhängigkeit der vorgenommenen Präparation, insbesondere die Protonendichte, der longitudinale Magnetisierungszerfall (T1) und Diffusionsparameter zu nennen.

Aus zumindest zwei aus zu unterschiedlichen Echozeiten $TE_k$ aufgenommenen Messdatensätzen $MD_{jk}$ rekonstruierten Bilddaten $BD_{jk}$ einer Schicht $S_j$, und somit auf Basis von aufgenommenen Messdaten $MD_{imjk}$, kann auf bekannte Art und Weise eine Parameterkarte $KD_j$ eines in dem Untersuchungsobjekt in der Schicht $S_j$ vorliegende Materie charakterisierenden Parameters bestimmt werden (Block 117.b). Als Parameter, deren Verteilung in der Schicht $S_j$ aus unter Realisierung unterschiedlicher Echozeiten aufgenommener Messdatensätze $MD_{jk}$ rekonstruierten Bilddaten $BD_{jk}$ bestimmt werden können, sind (ggf. in Abhängigkeit der erzeugten Echosignale) insbesondere die Protonendichte, der transversale Magnetisierungszerfall (T2) und der effektive transversale Magnetisierungszerfall (T2*) zu nennen.

Figur 3 zeigt ein weiteres mögliches Schaltdiagramm einer denkbaren Wiederholung am Beispiel einer Diffusionspräparation, wobei der Verlauf von RF-Pulsen, von in Diffusionsrichtung geschalteten Gradienten $G_D$, von in Schichtselektionsrichtung geschalteten Gradienten $G_S$, von in Ausleserichtung geschalteten Gradienten $G_R$ und von in Phasenkodierrichtung geschalteten Gradienten $G_P$, sowie von Datenauslesezeiten ADC mit der Zeit t dargestellt ist.

Im Rahmen einer Diffusionspräparation wird in mindestens einer Wiederholung mindestens ein Diffusionsgradient $G_D$ in zumindest einer Diffusionsrichtung D geschaltet. Der b-Wert der geschalteten Diffusionsgradienten kann für verschiedene Wiederholungen, z.B. über eine Variation der Stärke (Amplitude) der geschalteten Diffusionsgradienten oder über eine Variation der Dauer der geschalteten Diffusionsgradienten, verändert werden. Dies ist vereinfacht durch die verschiedenen gestrichelt gezeichneten Diffusionsgradienten $G_D$, die in anderen Wiederholungen geschaltet werden können, veranschaulicht. Üblicherweise werden im Rahmen einer Diffusionsmessung in verschiedenen Wiederholungen Diffusionspräparationen mit mindestens zwei verschiedenen b-Werten (z.B. b=0 and b=1000) in mehreren, z.B. vier, Diffusionsrichtungen vorgenommen. Zur Verbesserung beispielsweise des Signal-zu-Rausch-Verhältnisses (SNR, engl. "signal to noise ratio") können Wiederholungen mit derselben Präparation wiederholt aufgenommen werden.

In dem gezeigten Beispiel wird die Diffusionspräparation der ersten Schicht weiterhin in üblicher Weise mit Hilfe eines RF-Anregungspulses RF1.1 und eines RF-Refokussierungspulses RF1.2 bewirkt. Es kann weiterhin wie in dem gezeigten Beispiel ein weiterer RF-Refokussierungspuls RF1.3 eingestrahlt werden, um weitere Echosignale in der ersten Schicht zu erzeugen, die in einem Ausleseschritt ADC.b, z.B. als Navigatordaten oder auch, insbesondere, wenn der RF-Refokussierungspuls RF1.3 auch auf die mindestens eine zweite Schicht wirkt, als weitere Messdaten zu einer weiteren Echozeit, aufgenommen werden können.

Während somit in einer Wiederholung in einer ersten Schicht Echosignale unter Verwendung einer (Diffusions-)Präparation erzeugt werden, werden in derselben Wiederholung in mindestens einer zweiten Schicht Echosignale nach einer Echozeit TE nach einer Anregung der mindestens einen zweiten Schicht mit mindestens einem RF-Anregungspuls RF2 erzeugt, wobei in dem gezeigten Beispiel die in der ersten Schicht und in der mindestens einen zweiten Schicht erzeugten Echosignale gleichzeitig in einem Ausleseschritt ADC.a als Messdaten kollabiert in einem Messdatensatz aufgenommen werden. Die kollabiert aufgenommenen Messdaten können mit Hilfe von aus Schichtmultiplexing-Verfahren bekannten Techniken in Messdatensätze getrennt werden, welche jeweils nur Messdaten der einzelnen Schichten enthalten. Sollen Echosignale in mehr als einer zweiten Schicht mit RF-Anregungspulsen RF2, RF2', RF2", RF2''' erzeugt werden, können die RF-Anregungspulse RF2, RF2', RF2", RF2''' beispielsweise als Multi-Band-RF-Pulse ausgebildet sein, die die mehreren zweiten Schichten simultan anregen.

Die erzeugten Echosignale können hierbei, wie in dem gezeigten Beispiel mit einer EPI-Sequenz aufgenommen werden, die einen oszillierenden Auslesegradienten $G_R$ und Gradientenblips in der Phasenkodierrichtung P während des Ausleseschrittes ADC.a schaltet, um die Echosignale aufzunehmen. Dabei können in einer Wiederholung in einem Ausleseschritt ADC.a alle Messdaten einer Schicht aufgenommen werden ("single shot EPI") oder in mehreren Wiederholungen jeweils ein in je einem Segment im k-Raum abgetasteter Teil der für eine Schicht aufzunehmenden Messdaten ("segmented EPI") aufgenommen werden. Aus den Messdaten der im Rahmen der EPI-Sequenz erzeugten Gradientenechosignale der mindestens einen zweiten Schicht können T2*-Karten erzeugt werden.

Es ist auch möglich die erzeugten Messdaten mittels einer (Diffusions-)TSE-Sequenz aufzunehmen (nicht dargestellt), wobei dann aus Messdaten der im Rahmen der TSE-Sequenz erzeugten Spinechosignale der mindestens einen zweiten Schicht T2-Karten erzeugt werden können.

Sowohl EPI- als auch TSE-Sequenzen gehören zu den Multiecho-Sequenzen, bei welchen nach einer Anregung mehrere, d.h. zumindest zwei, Echosignale in der angeregten Schicht erzeugt und aufgenommen werden.

In weiteren Wiederholungen können die mindestens eine zweite Schicht anregenden RF-Anregungspulse an einer anderen zeitlichen Position platziert werden, um andere Echozeiten TE zu erhalten. Beispielsweise können mit einem RF-Anregungspuls RF2' in der mindestens einen zweiten Schicht nach einer Echozeit TE' Echosignale aufgenommen werden.

Insbesondere in Wiederholungen mit einer Diffusionspräparation mit b-Wert b=0, d.h. in Wiederholungen, in denen ein Diffusionsgradient der Stärke Null (also effektiv: kein Diffusionsgradient) geschaltet wird, können RF-Anregungspulse RF2", RF2''' zur Erzeugung von Echosignalen in mindestens einer zweiten Schicht auch zeitlich weiter von dem Ausleseschritt ADC.a platziert werden, z.B. zwischen dem RF-Anregungspuls RF1.1 und dem Refokussierungspuls RF1.2 oder bereits kurz nach dem RF-Refokussierungspuls RF1.2, um lange Echozeiten TE" bzw. TE''' zu erreichen. Derartige lange Echozeiten TE", TE''' in Kombination mit relativ deutlich kürzeren Echozeiten TE, TE' ermöglichen eine genauere Bestimmung von transversalen Zerfallskonstanten.

In den Figuren 4 bis 6 sind mögliche schematische Schaltdiagramme erfindungsgemäßer Wiederholungen dargestellt, wobei eine Präparation durchgeführt wird, welche mindestens einen RF-Inversionspuls RF_i1 umfasst. In den Schaltdiagrammen der Figuren 4 bis 6 ist jeweils der Verlauf mit der Zeit t von RF-Pulsen zusammen mit Ausleseschritten ADC in der jeweils oberen Zeile und von während Ausleseschritten beispielhaft geschalteten Gradienten G (z.B. ein EPI-Auslesegradient) in der jeweils unteren Zeile dargestellt.

In Figur 4 wird zunächst ein auf eine erste Schicht 1 wirkender RF-Inversionspuls RF_i1 eingestrahlt, welcher nach einer Inversionszeit $TI_m$ von einem RF-Anregungspuls RF_x123 gefolgt wird. Die Inversionszeit $TI_m$ ist eine von mindestens zwei zu verschiedenen Präparationen gehörenden Inversionszeiten $TI_1$ bis $TI_M$. In dem Beispiel der Figur 4 ist der RF-Anregungspuls RF_x123 als Multi-Band-RF-Puls ausgebildet, der simultan auf die erste Schicht 1 und auf eine erste zweite Schicht 2 und auf eine zweite zweite Schicht 3 wirkt, um Echosignale der Schichten 1, 2 und 3 zu erzeugen, die in dem Ausleseschritt $ADC_{123mk}$ kollabiert aufgenommen werden und unter Anwendung von aus Schichtmultiplexing-Verfahren bekannten Techniken in Messdatensätze der einzelnen Schichten getrennt werden können.

Um in der ersten Schicht 1 inversionspräparierte Echosignale zu erzeugen wird nach einer halben Echozeit $TE_k/2$ ein RF-Refokussierungspuls RF_r12 eingestrahlt, der in dem gezeigten Beispiel nicht nur auf die erste Schicht 1, sondern - wiederum insbesondere als Multi-Band-RF-Puls - auch auf die erste zweite Schicht 2 wirkt, wodurch in der ersten zweiten Schicht Spinechosignale erzeugt werden. In der zweiten zweiten Schicht 3 werden die Spins nur durch den RF-Anregungspuls RF_r123 angeregt, wodurch Gradientenechosignale erzeugt und in dem Ausleseschritt $ADC_{123mk}$ aufgenommen werden. In dem Beispiel der Figur 4 ist die Echozeit $TE_k$ für alle Schichten 1, 2, 3 gleich.

Um gemäß eines transversalen Zerfalls unterschiedlich gewichtete Echosignale erzeugen zu können, muss die in der ersten und zweiten zweiten Schicht 2 und 3 verwendete Echozeit in zumindest einer Wiederholung variiert werden. Daher ist in Figur 5 ist das Schaltdiagramm von Figur 4 derart geändert, dass in der ersten zweiten Schicht 2 und in der zweiten zweiten Schicht 3 Echosignale nach einer gemeinsamen Echozeit $TE_{23k}$ erzeugt und aufgenommen werden, die inversionspräparierten Echosignale der ersten Schicht 1 jedoch mit einer von der Echozeit $TE_{23k}$ verschiedenen Echozeit $TE_1$.

In einer Wiederholung gemäß einem in der Figur 5 dargestellten Beispiel werden in der ersten Schicht 1 ein RF-Inversionspuls RF_i1 und nach einer Inversionszeit $TI_m$ ein RF-Anregungspuls RF_x1 und nach diesem nach einer halben Echozeit $TE_1/2$ ein RF-Refokussierungspuls RF_r1 eingestrahlt, um nach der Echozeit $TE_1$ nach dem RF-Anregungspuls RF_x1 inversionspräparierte Echosignale zu erzeugen. In derselben Wiederholung wird nach dem RF_Inversionspuls RF_i1 ein RF-Anregungspuls RF_x23 eingestrahlt, der Spins in der ersten und zweiten zweiten Schicht 2 und 3 anregt und Gradientenechosignale der zweiten zweiten Schicht 3 erzeugt. Dazu kann der RF-Anregungspuls RF_x23 als Multi-Band-RF-Puls ausgebildet sein. Nach einer halben Echozeit $TE_{23k}/2$ nach dem eingestrahlten RF-Anregungspuls RF_x23 wird ein RF-Refokussierungspuls RF_r2 eingestrahlt, der die Spins in der ersten zweiten Schicht 2 refokussiert und nach der Echozeit TE$_{23k}$ nach dem eingestrahlten RF-Anregungspuls RF_x23 Spinechosignale der ersten zweiten Schicht erzeugt. Die erzeugten inversionspräparierten Echosignale der ersten Schicht 1, die erzeugten Spinechosignale der ersten zweiten Schicht 2 und die erzeugten Gradientenechosignale der zweiten zweiten Schicht 3 werden, analog zu Figur 4, kollabiert in Ausleseschritt ADS$_{123mk}$ aufgenommen.

In Figur 6 ist ein weiteres Schaltdiagramm einer Wiederholung mit Inversionspräparation dargestellt, welches besonders bei langen Inversionszeiten TI$_m$ von Vorteil sein kann.

Werden Wiederholungen mit langen gewünschten Inversionszeiten TI$_m$ durchgeführt, können auf die erste und zweite zweite Schicht 2 und 3 wirkende RF-Pulse und Echosignale der ersten und zweiten zweiten Schicht 2, 3 aufnehmende Ausleseschritte ADC$_{23k}$ zwischen den auf die erste Schicht 1 wirkenden Inversionspuls RF_i1 und den die inversionspräparierten Echosignale der ersten Schicht 1 aufnehmenden Ausleseschritt ACD$_{1m}$ eingefügt werden. Es kann sogar möglich sein auf die erste und zweite zweite Schicht 2 und 3 wirkende RF-Pulse und Echosignale der ersten und zweiten zweiten Schicht 2, 3 aufnehmende Ausleseschritte ADC$_{23k}$ zwischen den auf die erste Schicht 1 wirkenden Inversionspuls RF_i1 und den auf die erste Schicht 1 wirkenden RF-Anregungspuls RF_x1 einzufügen.

Auch in Figur 6 werden in einer ersten Schicht 1 inversionspräparierte Echosignale, in einer ersten zweiten Schicht 2 Spinechosignale und in einer zweiten zweiten Schicht 3 Gradientenechosignale erzeugt. Wie bereits in Figur 5 werden in dem hier gezeigten Beispiel in der ersten zweiten Schicht 2 und in der zweiten zweiten Schicht 3 Echosignale nach einer gemeinsamen Echozeit TE$_{23k}$ erzeugt und aufgenommen, die inversionspräparierte Echosignale der ersten Schicht 1 jedoch mit einer von der Echozeit TE$_{23k}$ verschiedenen Echozeit TE$_1$.

Somit ist das Schaltdiagramm der Figur 6 für die erste Schicht 1 wieder nur bezüglich der Dauer der Inversionszeit TI$_m$ gegenüber den Schaltdiagrammen der Figuren 3 und 5 verändert. Somit vergeht zwischen dem RF-Inversionspuls RF_i1 und dem RF-Anregungspuls RF_x1 hier eine längere Inversionszeit TI$_m$. Der RF-Refokussierungspuls RF_r1 ist jedoch unverändert nach einer halben Echozeit TE$_1$/2 nach dem RF-Anregungspuls RF_x1 und der Ausleseschritt ADC$_{1m}$ nach einer vollen Echozeit TE$_1$ nach dem RF-Anregungspuls RF_x1 angeordnet.

Im Vergleich zu Figur 5 sind aber in Figur 6 alle auf die zweiten Schichten 2, 3 wirkenden RF-Pulse RF_x23, RF_r2 zeitlich zwischen dem Inversionspuls RF_i1 und dem RF-Anregungspuls RF_x1 der ersten Schicht angeordnet. Der Übersichtlichkeit halber wurde auch in Figur 6 der Fall dargestellt, dass die zweiten Schichten 2 und 3 gleichzeitig mit einem als Multi-Band-RF-Puls ausgebildeten RF-Anregungspuls RF_x23 angeregt werden und die in den zweiten Schichten 2,3 erzeugten Echosignale kollabiert in einem Ausleseschritt ADC$_{23k}$ aufgenommen werden, womit hier aus Schichtmultiplexing-Verfahren bekannte Techniken eingesetzt werden. Auch der Ausleseschritt ADC$_{23k}$ liegt in dem gezeigten Beispiel zeitlich zwischen dem Inversionspuls RF_i1 und dem RF-Anregungspuls RF_x1 der ersten Schicht angeordnet.

Ebenfalls denkbar, aber nicht dargestellt, ist es, bei entsprechend langen Inversionszeiten TI$_m$, und damit innerhalb der Wiederholung gebotenen zeitlichem Raum, auch die RF-Pulse welche jeweils auf die erste und zweite zweite Schicht wirken als Einzel-RF-Pulse getrennt einzustrahlen und auch Ausleseschritte ADC$_2$ und ADC$_3$ für Echosignale der ersten und zweiten zweiten Schicht 2 und 3 getrennt durchzuführen. Dies ist insbesondere für Wiederholungen denkbar, in welchen Aufnahmen von Echosignalen der ersten und zweiten zweiten Schichten 2, 3 zu weiteren (auch jeweils) verschiedenen Echozeiten gewünscht sind. Beispielsweise können die jeweils für die erste und zweite zweite Schicht 2 und 3 einzustrahlenden (Einzel-)-RF-Anregungspulse und der in die erste zweite Schicht 2 einzustrahlende RF-Refokussierungspuls zeitlich nach dem in der ersten Schicht 1 eingestrahlten Inversionspuls RF_i1 und dem zugehörigen RF-Anregungspuls RF_x1 eingestrahlt werden. Die Ausleseschritte zur Aufnahme der Echosignale der ersten und zweiten zweiten Schicht 2 und 3 können hingegen zeitlich nach dem RF-Anregungspuls RF_x1 der ersten Schicht 1 und vor dem Ausleseschritt ADC$_{1m}$ der Aufnahme der Echosignale der ersten Schicht 1 durchgeführt werden.

In den Schaltdiagrammen der Figuren 4 bis 6 werden jeweils in einer Wiederholung in einer ersten Schicht 1 inversionspräparierte Echosignale, in einer ersten zweiten Schicht 2 mittels eines RF-Refokussierungspulses refokussierte Spinechosignale und in einer zweiten zweiten Schicht 3 durch einen RF-Anregungspuls erzeugte Gradientenchosignale erzeugt. Die Figuren 4 bis 6 geben somit Beispiele wie in jeweils einer Wiederholung gleichzeitig inversionspräparierte Echosignale, mittels RF-Refokussierungspulsen refokussierte, T2-gewichtete Spinechosignale und T2*-gewichtete Gradienechosignale in jeweils verschiedenen Schichten erzeugt werden können.

Im Vergleich zu jeweils einzeln durchgeführten Messungen wie es in dem bereits genannten Artikel von Poupon et al. vorgeschlagen wird, kann durch jeweils gleichzeitige Messung verschieden gewichteter Echosignale aus jeweils anderen Schichten die Messzeit um einen Faktor verkürzt werden, der in etwa der Anzahl der Schichten entspricht, aus denen in jeweils einer Wiederholung Echosignale aufgenommen werden. Wie bereits erwähnt, kann die Wiederholzeit TR, nach welcher Anregungen zur Erzeugung von Echosignalen und Aufnahmen der erzeugten Echosignale wiederholt werden können, bei kontrastgewichteten Messungen, deren Wiederholzeit von dem gewünschten Kontrast abhängt, nicht durch bekannte Schichtmultiplexing-Verfahren verkürzt werden. Mit einem erfindungsgemäßen Verfahren, das in einer Wiederholung verschiedene Kontrastgewichtungen in verschiedenen jeweils verschiedenen Schichten verschachtelt erzeugt, kann dennoch ein signifikanter Zeitgewinn bei der Erzeugung von unterschiedlich kontrastgewichteten Messdaten erreicht werden, da z.B. in einer Schicht abzuwartende Inversionszeiten TI oder Wiederholzeiten TR für die Manipulation mindestens einer anderen Schicht genutzt werden.

Die ggf. kollabiert aufgenommenen Messdaten verschiedener Schichten können unter Verwendung von aus Schichtmultiplexing-Verfahren bekannten Techniken in inversionspräparierte Messdatensätze, T2-gewichtete Messdatensätze und T2*-gewichtete Messdatensätze jeweils aller gemessener Schichten getrennt werden. Somit können aus Messdatensätzen erster Schichten 1 zumindest eine Karte eines von der Inversionszeit TI abhängigen Parameters, aus Messdatensätzen ersten zweiter Schichten 2 eine T2-Karte und aus Messdatensätzen zweiter zweiter Schichten 3 eine T2*-Karte (und jeweils eine Protonendichte-Karte) erstellt werden.

Die Schaltdiagramme der Figuren 4 bis 6 geben Beispiele für mögliche Schaltungen einzustrahlender RF-Pulse und zu schaltender Ausleseschritte, wobei die einzustrahlenden RF-Pulse teilweise auf mehrere Schichten wirken und in verschiedenen Wiederholungen gegeneinander versetzt eingestrahlt werden können. Welche Art Schaltdiagramm in einer bestimmten Wiederholung angewendet wird, hängt insbesondere von den gewünschten Präparationen, hier also z.B. von den gewünschten verschiedenen Inversionszeiten $TI_m$, und von den gewünschten verschiedenen Echozeiten $TE_k$, nach welchen in den zweiten Schichten 2,3 Echosignale aufgenommen werden sollen, ab.

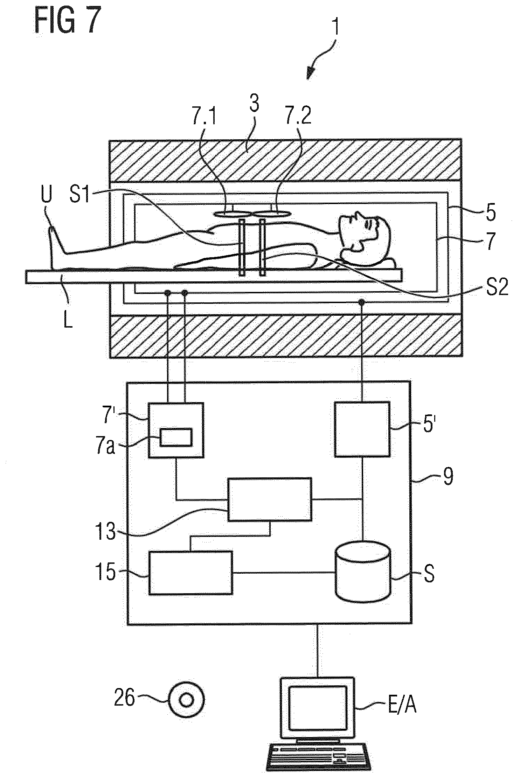

Figur 7 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 7 sind diese Teileinheiten der Magnetresonanzanlage 1 nur grob schematisch dargestellt. Insbesondere besteht die Hochfrequenzeinheit 7 aus mehreren Untereinheiten, insbesondere aus mindestens zwei Spulen wie den schematisch gezeigten Spulen 7.1 und 7.2, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schichten S1 und S2 stellen exemplarisch zwei unterschiedlichen Schichten S1 und S2 des Untersuchungsobjekts dar, die bei einer Aufnahme von MR-Signalen gleichzeitig gemessen werden können.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (insbesondere in verschiedene Schichten S1 und S2) des Untersuchungsobjekt U zuständig. Dabei sollte die Mittenfrequenz des auch als B1-Feld bezeichneten Hochfrequenz-Wechselfeldes nahe der Resonanzfrequenz der zu manipulierenden Spins liegen. Zur Erzeugung des B1-Feldes werden in der Hochfrequenzeinheit 7 mittels der Hochfrequenz-sende/empfangs-Steuerung 7' gesteuerte Ströme an den HF-Spulen angelegt. Die Hochfrequenzeinheit 7 ist dabei insbesondere dazu ausgebildet, für Schichtmultiplexing-Verfahren geeignete RF-Pulse zu erzeugen, z.B. mit entsprechend aufgeprägten zusätzlichen Phasen. Eine Multi-Band-RF-Pulseinheit 7a, die beispielsweise von der Hochfrequenz-Sende-/Empfangs-Steuerung 7' umfasst sein kann, berechnet Multi-Band-RF-Pulse zur gleichzeitigen Manipulation von verschiedenen Schichten S1, S2 in dem Untersuchungsobjekt U.

Weiterhin umfasst die Steuereinrichtung 9 eine Präparations-/Echozeiteinheit 15 zum Bestimmen von Abfolgen von einzustrahlenden RF-Pulsen und zu schaltenden Gradienten, um die gewünschten Präparationen und Echozeiten zu realisieren.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Insbesondere ist die Recheneinheit 13 auch dazu ausgebildet, in einem Messdatensatz kollabiert aufgenommene Messdaten verschiedener Schichten in Messdaten der jeweils einzelnen Schichten zu trennen. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

**Patentansprüche**

1. Verfahren zur Erzeugung von unterschiedlich kontrastgewichteten Messdaten eines Untersuchungsobjektes mittels Magnetresonanztechnik, umfassend die Schritte:

a) Wählen einer Anzahl (N) von verschiedenen zu messenden Schichten ($S_1$ ... $S_N$), einer Anzahl von gewünschten ersten Kontrastierungsmessparametern zur Erzeugung von mit einem gewünschten ersten Kontrast gewichteten Messdaten und jeweils einer weiteren Anzahl von gewünschten zweiten Kontrastierungsparametern zur Erzeugung von mit zumindest einem zweiten Kontrast gewichteten Messdaten, wobei der erste Kontrast und die zweiten Kontraste jeweils verschieden sind,
b) Anregen einer Schicht der zu messenden Schichten ($S_1$ ... $S_N$) unter Verwendung eines ersten Kontrastierungsmessparameters,
c) Anregen zumindest einer anderen Schicht der zu messenden Schichten ($S_1$ ... $S_N$) unter Verwendung eines zweiten Kontrastierungsmessparameters,
d) Aufnehmen von erzeugten Echosignalen der angeregten Schichten ($S_i$, $S_j$) als Messdaten und Speichern der Messdaten in einem Messdatensatz ($MD_{imjk}$),
e) Wiederholen der Schritte b) bis d) unter Verwendung von unterschiedlichen ersten Kontrastierungsmessparametern der gewünschten ersten Kontrastierungsparameter und unter Verwendung von unterschiedlichen zweiten Kontrastierungsmessparametern der gewünschten zweiten Kontrastierungsparameter bis alle zu messenden Schichten ($S_1$ ... $S_N$) zumindest einmal mit jedem gewünschten ersten Kontrastierungsmessparameter und zumindest einmal mit jedem gewünschten zweiten Kontrastierungsmessparameter angeregt wurden, und die dabei erzeugten Echosignale in einem Messdatensatz ($MD_{imjk}$) gespeichert wurden, **dadurch gekennzeichnet, dass** in Schritt c) zumindest eine erste zweite Schicht unter Verwendung eines ersten zweiten Kontrastierungsmessparameters und eine zweite zweite Schicht unter Verwendung eines zweiten zweiten, von dem ersten zweiten Kontrastierungsparameter verschiedenen, Kontrastierungsparameters als zumindest eine andere Schicht angeregt werden, wobei die eine in Schritt b) angeregte Schicht und die in Schritt c) angeregten erste zweite Schicht und zweite zweite Schicht jeweils verschieden sind, und wobei in den angeregten Schichten erzeugte Echosignale in je einer der angeregten Schichten als inversionspräparierte Echosignale, als Gradientenechosignale und als Spinechosignale erzeugt werden.

2. Verfahren nach Anspruch 1, wobei gewünschte Kontrastierungsmessparameter gewünschte Echozeiten ($TE_1$ ... $TE_K$) sind, und in jeder Wiederholung zumindest eine Schicht ($S_j$) derart angeregt wird, dass eine Echozeit ($TE_k$) der gewünschten Echozeiten ($TE_1$ ... $TE_K$) realisiert wird.

3. Verfahren nach einem der vorhergehenden Ansprüche, wobei die gewünschten ersten Kontrastierungsmessparameter gewünschte Präparationen ($Pr_1$ ... $Pr_M$) sind, und in jeder Wiederholung eine Schicht ($S_i$) der zu messenden Schichten ($S_1$ ... $S_N$) unter Verwendung einer Präparation ($Pr_m$) der gewünschten Präparationen ($Pr_1$ ... $Pr_M$) angeregt wird.

4. Verfahren nach einem der vorhergehenden Ansprüche, wobei in mindestens einer Wiederholung das Anregen der einen Schicht gemäß Schritt b) und das Anregen der zumindest einen anderen Schicht gemäß Schritt c) derart erfolgen, dass Echosignale aus der einen Schicht und aus der zumindest einen anderen Schicht simultan erzeugt und kollabiert in einem Messdatensatz ($MD_{imjk}$) gespeichert werden.

5. Verfahren nach Anspruch 2, wobei die gewünschten Präparationen ($Pr_1$ ... $Pr_M$) Präparationen eines Präparationstyps aus der Gruppe von Präparationstypen umfassen, welche zumindest einen RF-Inversionspuls zu einer bestimmten Inversionszeit als Präparationswert oder welche zumindest einen RF-Magnetisierungstransferpuls mit einer bestimmten spektralen Selektivität als Präparationswert umfassen.

6. Verfahren nach einem der vorhergehenden Ansprüche, wobei das Anregen von Schichten ($S_i$, $S_j$) gemäß der Schritte b) und c) innerhalb einer Wiederholung zumindest einen Multi-Band-RF-Puls umfasst, welcher zumindest zwei der in den Schritten b) und c) angeregten Schichten ($S_i$, $S_j$) gleichzeitig manipuliert.

**7.** Verfahren nach einem der vorhergehenden Ansprüche, wobei aufgenommene Messdaten von simultan erzeugten Echosignalen verschiedener Schichten ($S_i$, $S_j$) unter Verwendung einer parallelen Akquisitionstechnik in jeweilige Einzelschicht-Messdaten ($MD_{im}$, $MD_{jk}$) getrennt werden.

**8.** Verfahren nach einem der vorhergehenden Ansprüche, wobei auf Basis der gespeicherten Messdatensätze ($MD_{imjk}$) gemäß dem ersten Kontrast und gemäß dem zweiten Kontrast gewichtete Bilddaten ($BD_{im}$, $BD_{jk}$) rekonstruiert werden.

**9.** Verfahren nach einem der vorhergehenden Ansprüche, wobei auf Basis der gespeicherten Messdatensätze ($MD_{imjk}$) zumindest eine Parameterkarte ($KD_i$, $KD_j$) eines in dem Untersuchungsobjekt vorliegende Materie charakterisierenden Parameters bestimmt wird.

**10.** Verfahren nach einem der vorhergehenden Ansprüche, wobei in den Schritten b) und/oder c) durch die jeweilige Anregung zumindest zwei Echosignale in der jeweils angeregten Schicht erzeugt werden, die in Schritt d) aufgenommen werden.

**11.** Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Präparations-/Echozeiteinheit (15), wobei die Steuereinrichtung (9) dazu ausgebildet ist, ein Verfahren nach einem der Ansprüche 1 bis 10 auf der Magnetresonanzanlage (1) auszuführen.

**12.** Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 10 auszuführen, wenn das Programm in der Steuereinrichtung (9) der Magnetresonanzanlage (1) ausgeführt wird.

**13.** Elektronisch lesbarer Datenträger mit darauf gespeicherten elektronisch lesbaren Steuerinformationen, welche zumindest ein Computerprogramm nach Anspruch 12 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 10 durchführen.

**Claims**

**1.** Method for generating differently contrast-weighted scan data of an examination object by means of magnetic resonance technology, comprising the steps:

    a) selection of a number (N) of different slices ($S_1$ ... $S_N$) to be scanned, a number of desired first contrasting scan parameters for generating scan data weighted with a desired first contrast and, in each case, a further number of desired second contrasting parameters for generating scan data weighted with at least one second contrast, wherein the first contrast and the second contrasts are each different,

    b) excitation of one slice of the slices ($S_1$ ... $S_N$) to be scanned using a first contrasting scan parameter,

    c) excitation of at least one other slice of the slices ($S_1$ ... $S_N$) to be scanned using a second contrasting scan parameter,

    d) recording of generated echo signals of the excited slices ($S_i$, $S_j$) as scan data and storing the scan data in a scan data set ($MD_{imjk}$),

    e) repetition of the steps b) to d) using different first contrasting scan parameters of the desired first contrasting parameters and using different second contrasting scan parameters of the desired second contrasting parameters until all the slices to be scanned ($S_1$ ... $S_N$) have been excited at least once with each desired first contrasting scan parameter and at least once with each desired second contrasting scan parameter and the echo signals generated thereby have been stored in a scan data set ($MD_{imjk}$),

**characterised in that** in step c), using a first second contrasting scan parameter, at least one first second slice and, using a second second contrasting parameter which differs from the first second contrasting parameter, a second second slice are excited as at least one other slice, wherein the slice excited in step b) and the first second slice and second second slice excited in step c) are different in each case and wherein echo signals generated in the excited slices are generated in each of the excited slices as inversion-prepared echo signals, as gradient echo signals and as spin echo signals.

**2.** Method according to claim 1, wherein desired contrasting scan parameters are desired echo times ($TE_1$ ... $TE_K$) and in each repetition, at least one slice ($S_j$) is excited such that an echo time ($TE_k$) of the desired echo times ($TE_1$ ... $TE_K$) is realised.

**3.** Method according to one of the preceding claims, wherein the desired first contrasting scan parameters are desired preparations ($Pr_1$ ... $Pr_M$), and in each repetition a slice ($S_i$) of the slices ($S_1$ ... $S_N$) to be scanned is excited using a preparation ($Pr_m$) of the desired preparations ($Pr_1$ ... $Pr_M$).

**4.** Method according to one of the preceding claims, wherein in at least one repetition, the excitation of the one slice according to step b) and the excitation of the at least one other slice according to step c) can take place such that echo signals from the one slice and from the at least one other slice are generated simultaneously and are stored collapsed in a scan data set ($MD_{imjk}$).

**5.** Method according to claim 2, wherein the desired preparations ($Pr_1 ... Pr_M$) comprise preparations of a preparation type from the group of preparation types which comprise at least one RF inversion pulse at a particular inversion time as a preparation value or which comprise at least one RF magnetisation transfer pulse with a particular spectral selectivity as a preparation value.

**6.** Method according to one of the preceding claims, wherein the excitation of slices ($S_i$, $S_j$) according to steps b) and c) within a repetition comprises at least one multi-band RF pulse which simultaneously manipulates at least two of the slices ($S_i$, $S_j$) excited in the steps b) and c) .

**7.** Method according to one of the preceding claims, wherein recorded scan data from simultaneously generated echo signals of different slices ($S_i$, $S_j$) are separated using a parallel acquisition technique into respective single-slice scan data ($MD_{im}$, $MD_{jk}$) .

**8.** Method according to one of the preceding claims, wherein on the basis of the stored scan data sets ($MD_{imjk}$) image data ($BD_{im}$, $BD_{jk}$) weighted according to the first contrast and according to the second contrast is reconstructed.

**9.** Method according to one of the preceding claims, wherein on the basis of the stored scan data sets ($MD_{imjk}$) at least one parameter map ($KD_i$, $KD_j$) of a parameter characterising a material present in the examination object is determined.

**10.** Method according to one of the preceding claims, wherein in the steps b) and/or c) by means of the respective excitation, at least two echo signals are generated in the respectively excited slice, which are recorded in step d).

**11.** Magnetic resonance system (1), comprising a magnet unit (3), a gradient unit (5), a high frequency unit (7) and a control device (9) with a high frequency transmission/receiving control unit (7') and a preparation/echo time unit (15), wherein the control device (9) is configured to carry out a method according to one of claims 1 to 10 on the magnetic resonance system (1).

**12.** Computer program which is directly loadable into a memory store of a control system (9) of a magnetic resonance system (1), having program means in order to carry out the steps of the method according to one of claims 1 to 10 when the program is executed in the control device (9) of the magnetic resonance apparatus (1).

**13.** Electronically readable data carrier with electronically readable control information stored thereon, said control information comprising at least one computer program according to claim 12 and configured such that, on use of the data carrier in a control device (9) of a magnetic resonance system (1), it carries out a method according to one of claims 1 to 10.

**Revendications**

**1.** Procédé de production de données de mesure pondérées en contraste de manière différente d'un objet à examiner au moyen de la technique de la résonance magnétique, comprenant les stades :

a) sélection d'un nombre (N) de couches ($S_1 ... S_N$) différentes à mesurer, d'un nombre de premiers paramètres souhaités de mesure de l'effet de contraste pour la production de données de mesure pondérées par un premier contraste souhaité et respectivement d'un autre nombre de deuxièmes paramètres souhaités de l'effet de contraste pour la production de données de mesurée pondérées par au moins un deuxième contraste, dans lequel le premier contraste et les deuxième contrastes sont respectivement différents,
b) excitation d'une couche parmi les couches ($S_1 ... S_N$) à mesurer en utilisant un premier paramètre de mesure de l'effet de contraste,
c) excitation d'au moins une autre couche parmi les couches ($S_1 ... S_N$) à mesurer en utilisant un deuxième paramètre de mesure de l'effet de contraste,
d) enregistrement de signaux d'écho produits des couches ($S_i$, $S_j$) excitées comme données de mesure et mise en mémoire des données de mesure en un ensemble ($MD_{imjk}$) de données de mesure,
e) répétition des stades b) à d) en utilisant des premiers paramètres de l'effet de contraste différents des premiers paramètres souhaités de l'effet de contraste et en utilisant des deuxième paramètres de mesure de l'effet de contraste différents des deuxième paramètres souhaités de l'effet de contraste jusqu'à ce que toutes les couches ($S_1 ... S_N$) à mesurer aient été excitées au moins une fois avec chaque premier paramètre souhaité de mesure de l'effet de contraste et au moins une fois avec chaque deuxième paramètre souhaité de mesure de l'effet de contraste et jusqu'à ce que les signaux d'écho ainsi produits aient été mis en mémoire en un ensemble ($MD_{imjk}$) de données de mesure,

**caractérisé en ce que**, dans le stade c) ont été excités comme au moins une autre couche au moins une première, deuxième couche, en utilisant un premier deuxième paramètre de mesure de l'effet de contraste, et une deuxième deuxième couche, en utilisant un deuxième deuxième paramètre d'effet de contraste différent du premier deuxième paramètre d'effet de contraste, dans lequel la une couche excitée dans le stade b) et la première deuxième couche excitée dans le stade c) et la deuxième deuxième couche sont respectivement différentes, et dans lequel des signaux d'écho, produits dans les couches excitées, sont produits dans respectivement l'une des couches excitées comme signaux d'écho préparés par inversion comme signaux d'écho de gradient ou comme signaux d'écho de spin.

2. Procédé suivant la revendication 1, dans lequel des paramètres souhaités de mesure de l'effet de contraste sont des temps ($TE_1 ... TE_K$) d'écho souhaités, et dans chaque répétition au moins une couche ($S_j$) est excitée, de manière à réaliser un temps ($TE_K$) d'écho parmi les temps ($TE_1 ... TE_K$) d'écho souhaités.

3. Procédé suivant l'une des revendications précédentes, dans lequel les premier paramètres souhaités de mesure de l'effet de contraste sont des préparations ($Pr_1 ... Pr_M$) souhaitées et dans chaque répétition une couche ($S_i$) parmi les couches ($S_1 ... S_N$) à mesurer est excitée en utilisant une préparation ($Pr_m$) parmi les préparations ($Pr_1 ... Pr_M$) souhaitées.

4. Procédé suivant l'une des revendications précédentes, dans lequel dans au moins une répétition l'excitation de la une couche suivant le stade b) et l'excitation de la au moins une autre couche suivant le stade c) s'effectuent, de manière à ce que des signaux d'écho à partir de la une couche et à partir de la au moins une autre couche soient produits simultanément et soient mis en mémoire en étant collationnés en un ensemble ($MD_{imjk}$) de données de mesure.

5. Procédé suivant la revendication 2, dans lequel les préparations ($Pr_1 ... Pr_M$) souhaitées comprennent des préparations d'un type de préparation choisi dans le groupe des types de préparation, qui comprennent au moins une impulsion d'inversion RF à un temps d'inversion déterminé comme valeur de préparation ou qui comprennent au moins une impulsion de transfert de magnétisation RF ayant une sélectivité spectrale déterminée comme valeur de préparation.

6. Procédé suivant l'une des revendications précédentes, dans lequel l'excitation de couche ($S_i$, $S_j$) suivant les stades b) et c) comprend une répétition d'au moins une impulsion RF multi-bandes, qui manipule en même temps au moins deux des couches ($S_i$, $S_j$) excitées dans les stades b) et c).

7. Procédé suivant l'une des revendications précédentes, dans lequel les données de mesure enregistrées de signaux d'écho produits simultanément de couches ($S_i$, $S_j$) différentes sont séparées en des données ($MD_{im}$, $MD_{jk}$) de mesure de couche individuelle respectives en utilisant une technique d'acquisition parallèle.

8. Procédé suivant l'une des revendications précédentes, dans lequel sur la base des ensembles ($MD_{imjk}$) de données de mesure mis en mémoire, on reconstruit des données ($BD_{im}$, $BD_{jk}$) d'image pondérées suivant le premier contraste et suivant le deuxième contraste.

9. Procédé suivant l'une des revendications précédentes, dans lequel sur la base des ensembles ($MD_{imjk}$) de données de mesure mis en mémoire, on détermine au moins une carte ($KD_i$, $KD_j$) de paramètre d'un paramètre caractérisant une substance présente dans l'objet en examen.

10. Procédé suivant l'une des revendications précédentes, dans lequel dans les stades b) et/ou c) on produit dans la couche excitée respectivement par excitation respective au moins deux signaux d'écho, qui sont enregistrés au stade d).

11. Installation (1) de résonance magnétique, comprenant une unité (3) d'aimant, une unité (5) de gradient, une unité (7) de haute fréquence et un dispositif (9) de commande comprenant une commande (7') d'émission/réception de haute fréquence et une unité (15) de préparation/temps d'écho, dans laquelle le dispositif (9) de commande est constitué pour exécuter un procédé suivant l'une des revendications 1 à 10, sur l'installation (1) de résonance magnétique.

12. Programme d'ordinateur, qui peut être chargé directement dans une mémoire d'un dispositif (9) de commande d'une installation (1) de résonance magnétique, comprenant des moyens de programme pour exécuter les stades du procédé suivant l'une des revendications 1 à 10, lorsque le programme est exécuté dans le dispositif (9) de commande de l'installation (1) de résonance magnétique.

13. Support de données déchiffrable électroniquement, sur lequel sont mémorisées des informations de commande déchiffrables électroniquement, qui comprennent au moins un programme d'ordinateur suivant la revendication 12 et qui sont conformées, de manière à ce qu'elles effectuent lors de l'utilisation du support de données dans un dispositif (9) de commande d'une installation (1) de résonance magnétique, un procédé suivant l'une des revendications 1 à 10.

# FIG 1

$S_1 \ldots S_N$

$Pr_1 \ldots Pr_M$

$TE_1 \ldots TE_K$

101

103

$S_i, Pr_m; S_j, TE_k$

105.a

105

105.b

$(S_i', Pr_m'; S_j', TE_k')$

107

$MD_{imjk}$

113

n · y

109

n

111

y

$MD_{im}$

$MD_{jk}$

115.a

115.b

$BD_{im}$

$BD_{jk}$

117.a

117.b

$KD_i$

$KD_j$

# FIG 2

$Pr_{im}$

$RF\text{-}A_{jk}$

$TE_k$

RF ————————————————— t

G ————————————————— t

$ADC_{imjk}$

ADC ————————————————— t

# FIG 3

$TE''''$

$TE''$

$TE$

$TE'$

RF1.1

$RF2''''$

RF1.2

$RF2'''$

$RF2$

$RF2'$

RF1.3

RF ————————————————— t

$G_D$ ————————————————— t

$G_S$ ————————————————— t

$G_R$ ————————————————— t

$G_P$ ————————————————— t

ADC ————————————————— t

ADC.a

ADC.b

FIG 4

RF_r12

ADC$_{123mk}$

RF_x123

RF_i1

RF/ADC ——————— t

TI$_m$    TE$_k$/2    TE$_k$/2

G ——————— t

FIG 5

RF_r2   RF_r1

RF_x23

RF_x1

ADC$_{123mk}$

RF_i1

RF/ADC ——————— t

TI$_m$   TE$_{23k}$/2   TE$_1$/2   TE$_{23k}$/2   TE$_1$/2

G ——————— t

## FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2017108567 A1
- EP 17174507 A
- DE 102016218955
- US 20170108567 A1
- DE 102015222833 A1
- US 6097185 A
- US 4734646 A
- US 15139732 B
- US 15218388 B
- US 15221635 B

**In der Beschreibung aufgeführte Nicht-Patentliteratur**

- **BREUER et al.** Controlled Aliasing in Parallel Imaging Results in Higher Acceleration (CAIPIRINHA) for Multi-Slice Imaging. *Magnetic Resonance in Medicine,* 2005, vol. 53, 684-691
- **SETSOMPOP et al.** Blipped-Controlled Aliasing in Parallel Imaging for Simultaneous Multislice Echo Planar Imaging With Reduced g-Factor Penalty. *Magnetic Resonance in Medicine,* 2012, vol. 67, 1210-1224
- **POUPON et al.** Real-time EPI, T1, T2 and T2* mapping at 3T. *Proc. Intl. Soc. Mag. Reson. Med.,* 2010, vol. 18, 4983
- **DIETRICH et al.** Technical aspects of MR diffusion imaging of the body. *European Journal of Radiology,* 2010, vol. 76, 314-322
- **BREUTIGAM.** Simultaneous Multi-Contrast Imaging with ReadoutSegmented EPI. *Proc. Intl. Soc. Mag. Reson. Med.,* 2017, vol. 25, 520